# EUROPEAN PATENT APPLICATION

(11) **EP 4 510 796 A1**
(43) Date of publication of application: **19.02.2025**
(21) Application number: 23788028.1
(22) Date of filing: 21.02.2023
(51) Int. Cl.: H05K 9/00, G06F 1/18, H01R 12/73, H01R 13/6594

(54) **ELECTRONIC APPARATUS**

(30) Priority: 11.04.2022 JP 2022065376
(71) Applicant: Sony Interactive Entertainment Inc., Tokyo 108-0075 (JP)
(72) Inventor: TSUCHIDA, Shinya, Tokyo 108-0075 (JP)
(74) Representative: D Young & Co LLP
(86) International application number: PCT/JP2023/006288
(87) International publication number: WO 2023/199605

(57) **Abstract**

There is provided an electronic device that can increase the degree of freedom of the size and layout of a circuit board. The electronic device (1, 1000) has a circuit board (20, 1020), a connector (3c, 1003) mounted on an upper surface (20U, 1020U) of the circuit board, with a first end (100L) of a storage medium (100) being connectable to the connector, and a spacer (5c) that is attachable to and detachable from a member (40, 1050) different from the circuit board (20, 1020) and that supports a second end (100R) of the storage medium (100). The member (40, 1050) different from the circuit board has at least one positioning portion (4a, 1004) for positioning the spacer (5c). An upper surface (40U, 1050U) of the member having the at least one positioning portion (4a, 1004) is disposed lower than the circuit board (20, 1020) and the upper surface (20U, 1020U) of the circuit board.

## Description

### [Technical Field]

The present disclosure relates to an electronic device.

### [Background Art]

PTL 1 referred to below discloses an electronic device that is able to have a semiconductor memory installed thereon. In recent years, some storage media such as semiconductor memories installed in electronic devices such as game devices and personal computers have a terminal part on one end thereof for connection to a connector. For example, storage media conforming to the M.2 standard have such a terminal part.

### [Citation List]

### [Patent Literature]

[PTL 1]
PCT Patent Publication No. WO2021/193622

### [Summary]

### [Technical Problem]

Some electronic devices have a support structure for supporting an end (an end opposite to a terminal part) of a storage medium. The support structure includes a spacer that is provided to guarantee the distance between a circuit board and the reverse side of the storage medium so that electronic parts can be mounted on the reverse side of the storage medium, and that defines the height of the end of the storage medium from the circuit board, for example. Conventional electronic devices include a plurality of positioning structures provided on a circuit board for defining the position of a spacer. Since a space in which to provide those positioning structures is required on the circuit board, it is difficult to reduce the size of the circuit board. This has limited efforts to reduce the size and cost of the electronic devices.

It is an object of the present disclosure to provide an electronic device that is able to increase the degree of freedom of the size and layout of a circuit board thereof.

### [Solution to Problem]

An electronic device according to the present disclosure is an electronic device that is able to have a storage medium installed thereon, the storage medium having a first end with a terminal part formed thereon and a second end opposite to the first end. The electronic device includes a circuit board having a first surface facing in a first direction and a second surface facing in a second direction that is opposite to the first direction, a connector mounted on the first surface of the circuit board, the first end of the storage medium being connectable to the connector, and a member different from the circuit board. The member different from the circuit board has a third surface facing in the first direction and has at least one positioning portion formed on the third surface for positioning a spacer that supports the second end of the storage medium. The third surface is positioned in a direction along the circuit board with respect to the connector and positioned in the second direction rather than the first surface of the circuit board. This can increase the degree of freedom of the size and layout of the circuit board.

### [Brief Description of Drawings]

[FIG. 1A]

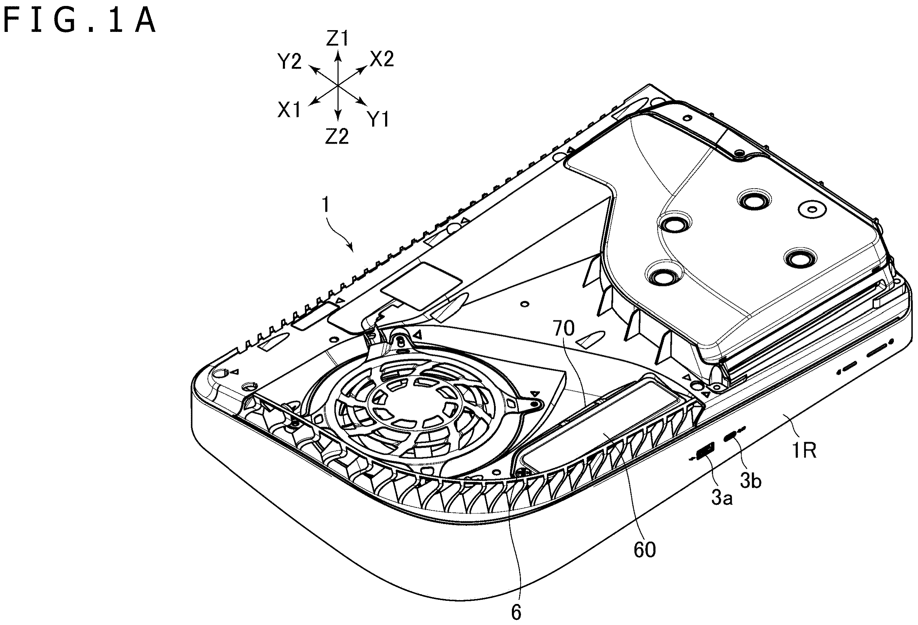

   FIG. 1A is a perspective view of an electronic device that is an example of an embodiment of the present disclosure.
[FIG. 1B]

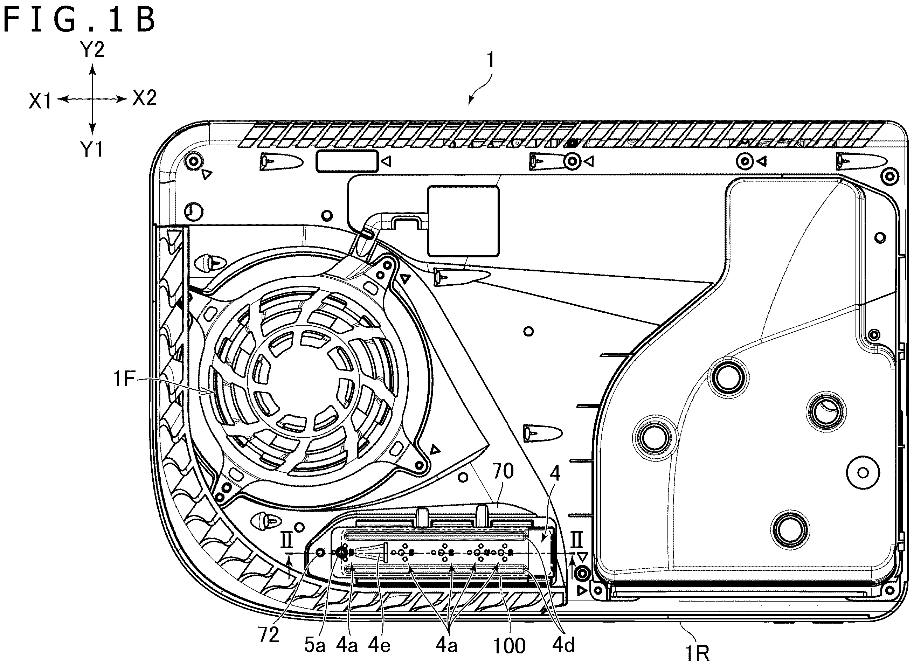

   FIG. 1B is a plan view of the electronic device.
[FIG. 1C]

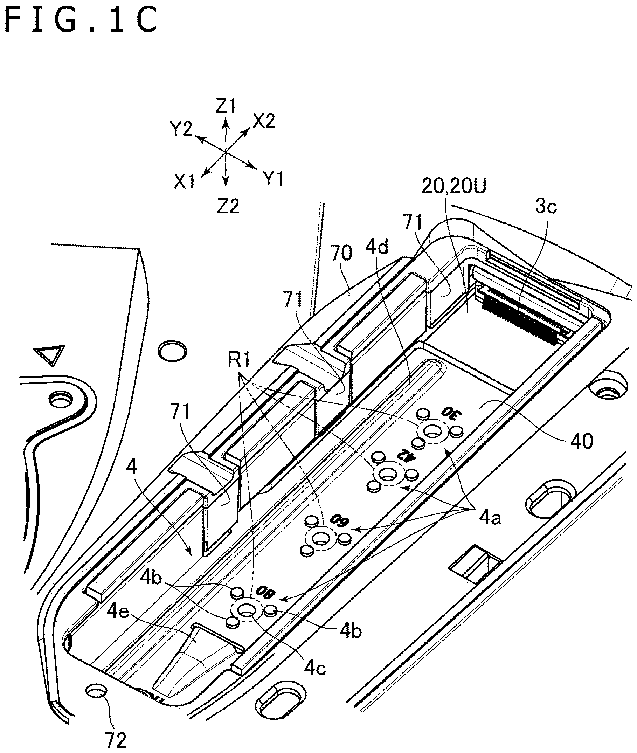

   FIG. 1C is a perspective view illustrating a housing chamber of the electronic device in which a storage medium is to be housed.
[FIG. 1D]

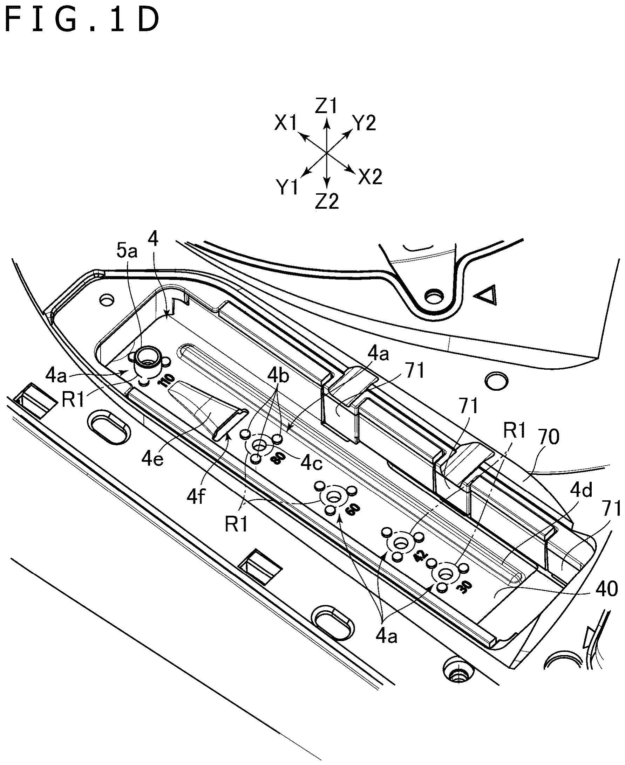

   FIG. 1D is a perspective view illustrating the housing chamber of the electronic device in which a storage medium is to be housed.
[FIG. 2]

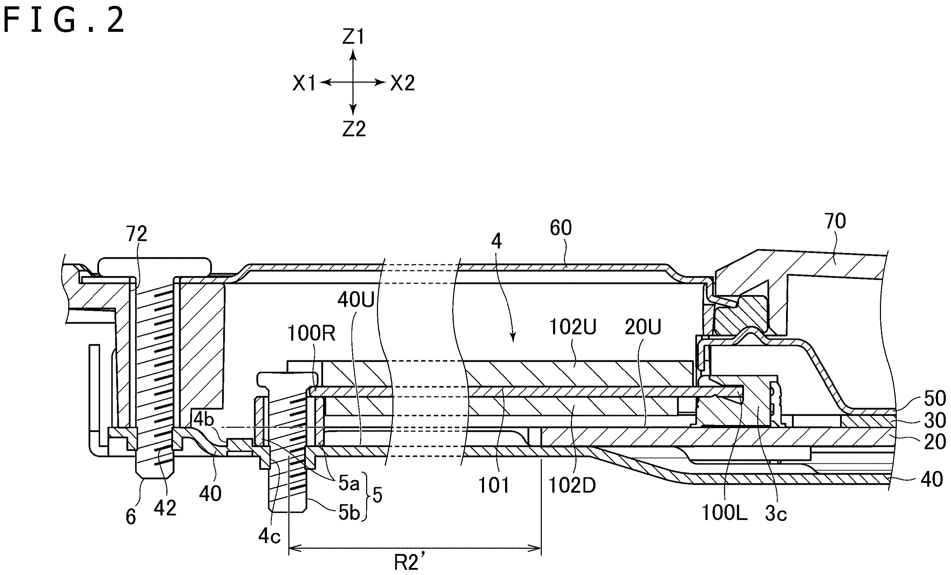

   FIG. 2 is a cross-sectional view of the electronic device obtained by a cross-sectional view including line II-II of FIG. 1B.
[FIG. 3A]

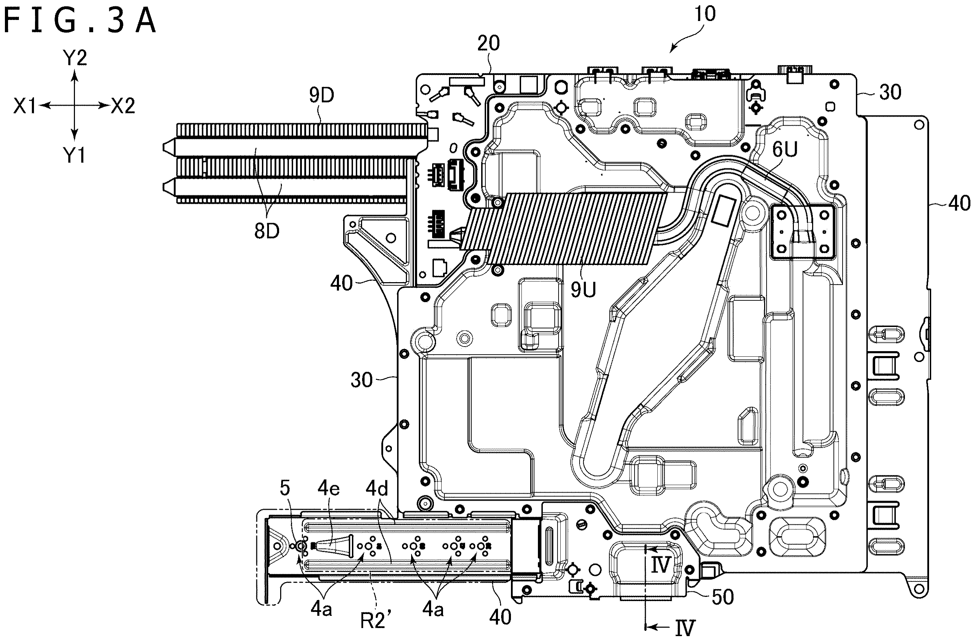

   FIG. 3A is a plan view of a circuit board unit housed inside the electronic device.
[FIG. 3B]

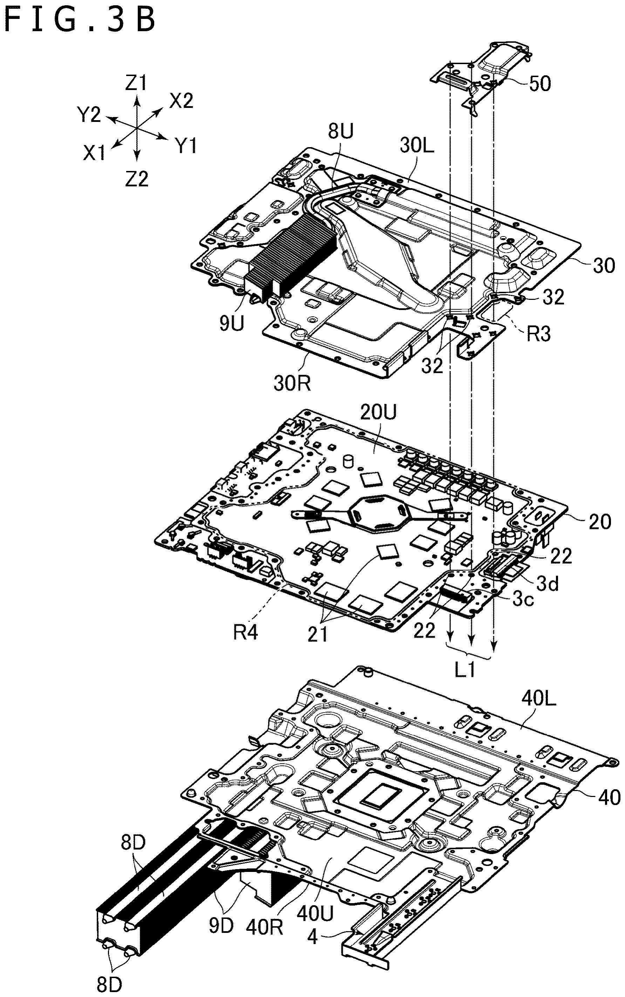

   FIG. 3B is an exploded perspective view illustrating constituent elements of the circuit board unit.
[FIG. 3C]

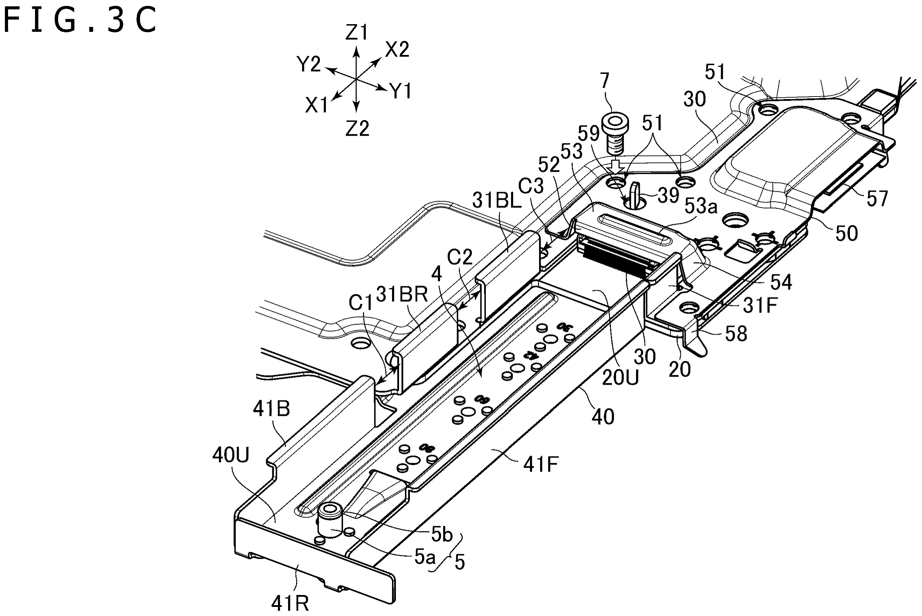

   FIG. 3C is a perspective view illustrating a peripheral part of a connector in the circuit board unit.
[FIG. 3D]

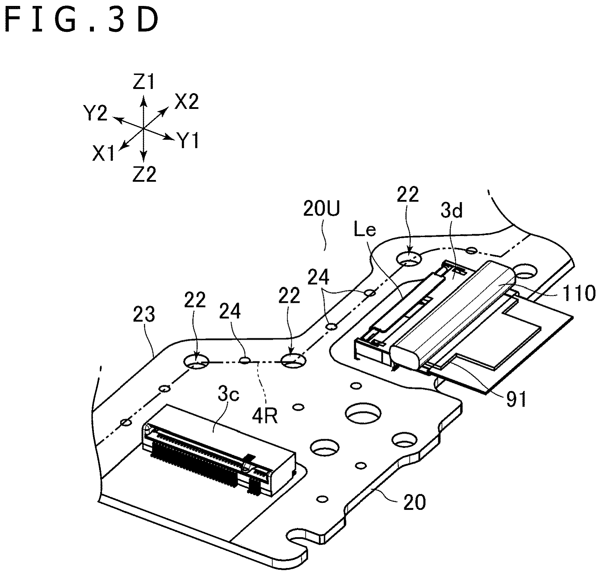

   FIG. 3D is a perspective view illustrating the peripheral part of the connector on a circuit board.
[FIG. 4]

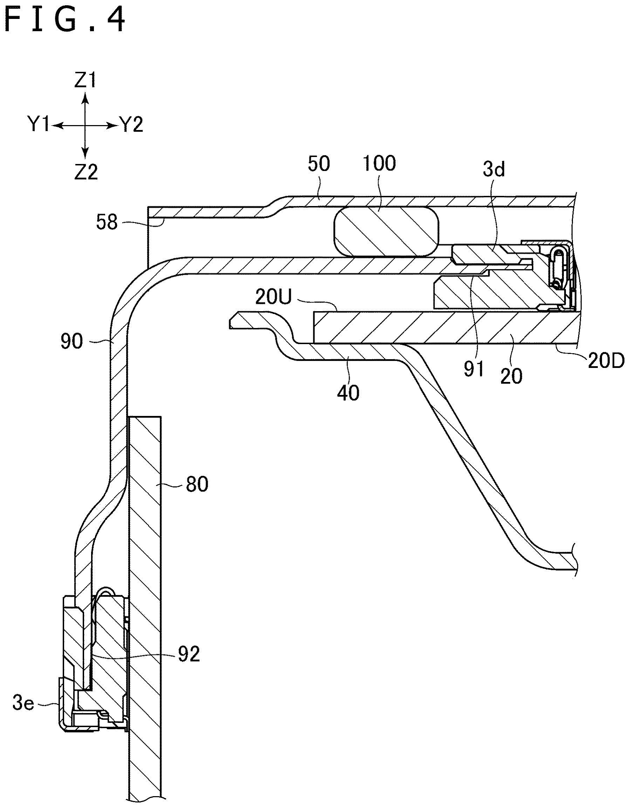

   FIG. 4 is a cross-sectional view of the electronic device obtained by a cross section along line IV-IV of FIG. 3A.
[FIG. 5]

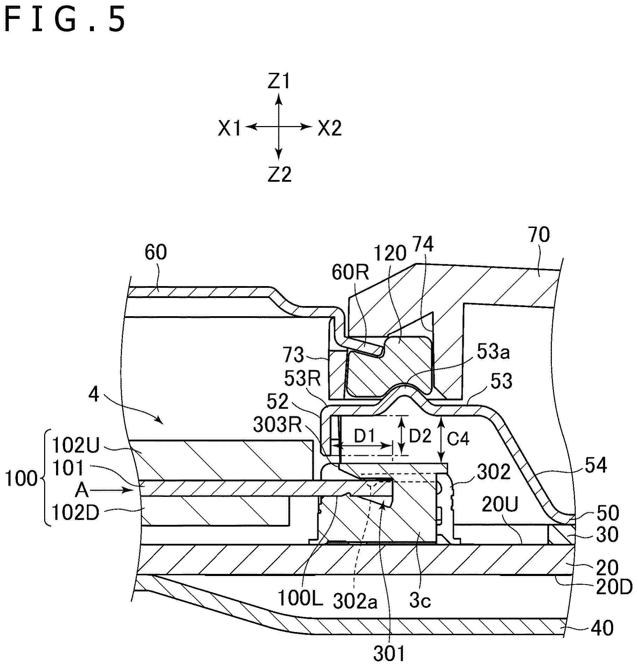

   FIG. 5 is an enlarged view of a peripheral part of the connector on the cross section illustrated in FIG. 2.
[FIG. 6]

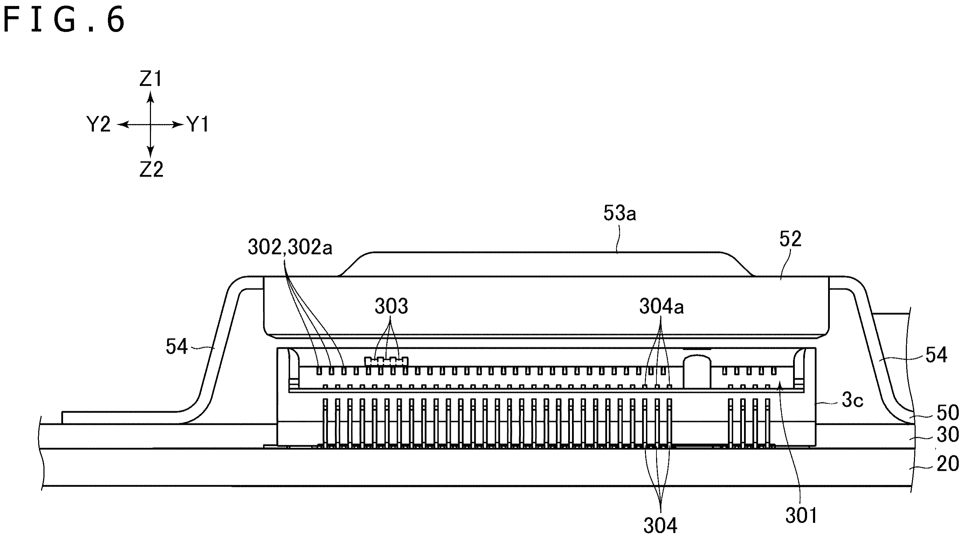

   FIG. 6 is a front view of the connector viewed in a direction of arrow A in FIG. 5.
[FIG. 7]

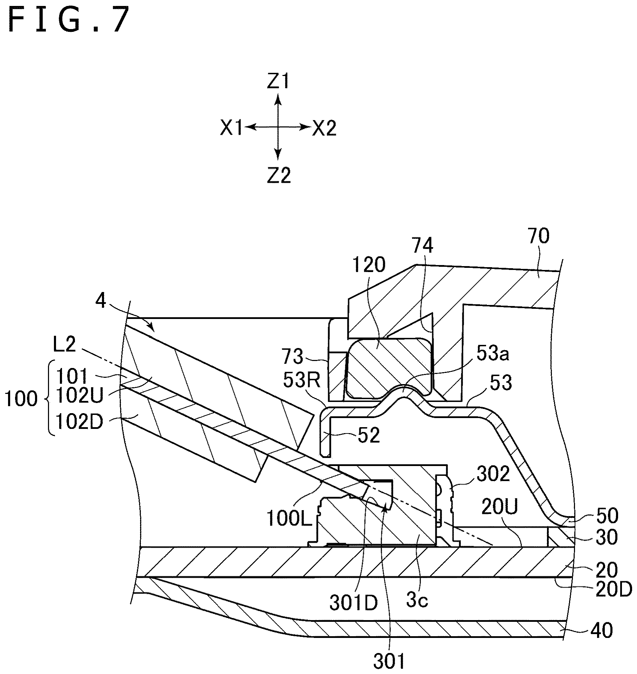

   FIG. 7 is a cross-sectional view illustrating a state in which a storage medium is being attached to the connector.
[FIG. 8]

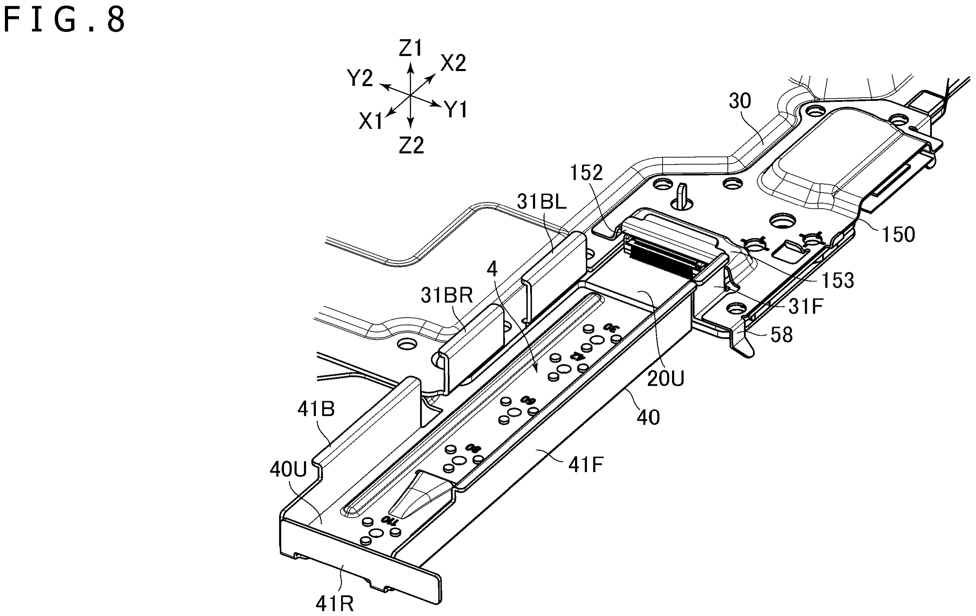

   FIG. 8 is a perspective view illustrating a periphery of a connector shield in a circuit board unit according to a modification.
[FIG. 9]

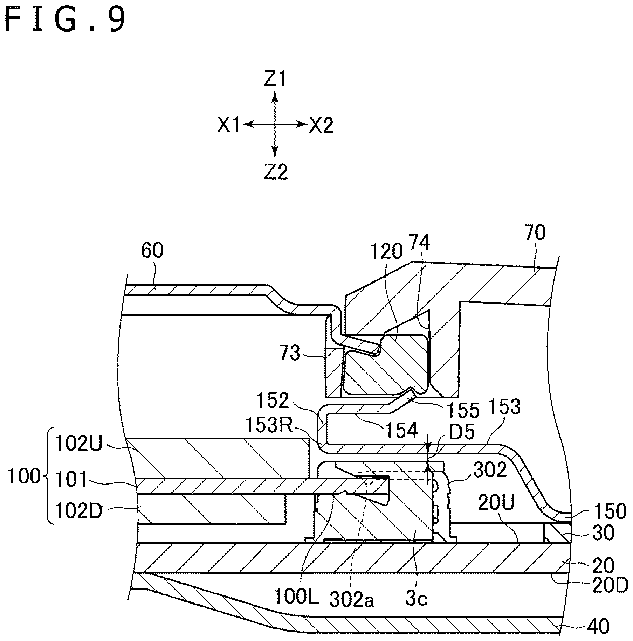

   FIG. 9 is a cross-sectional view of the electronic device around the connector shield.
[FIG. 10]

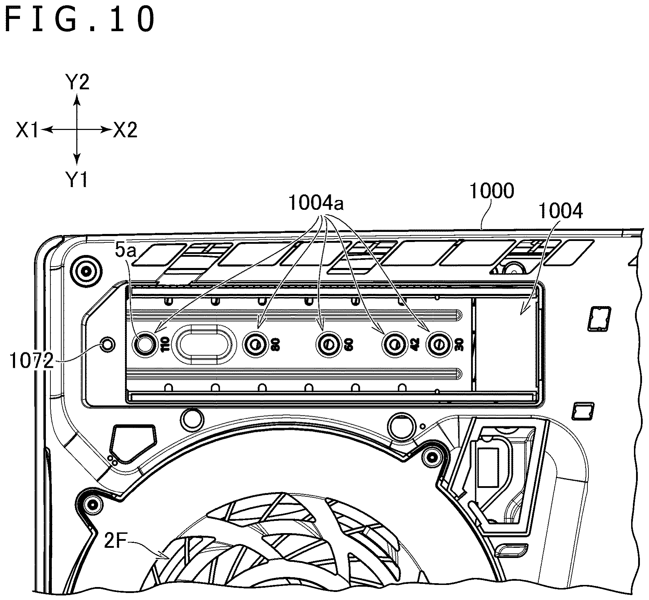

   FIG. 10 is a plan view illustrating a portion of an electronic device according to a second embodiment.
[FIG. 11A]

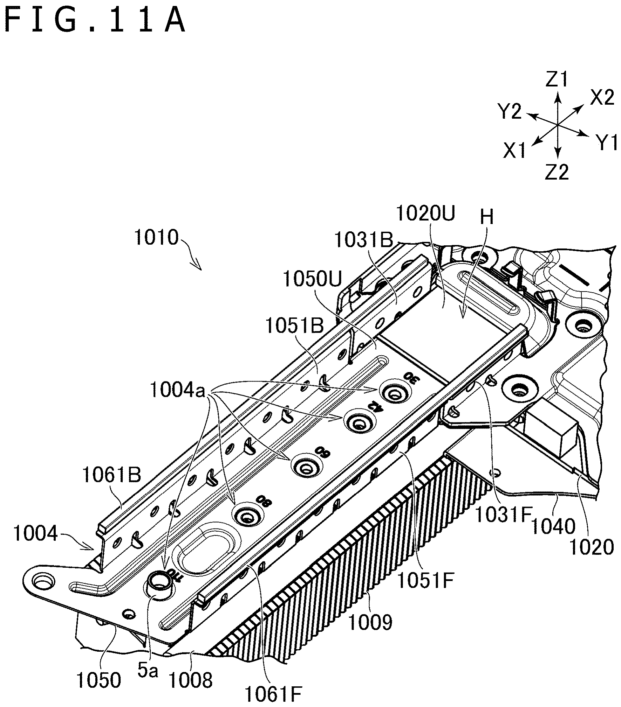

   FIG. 11A is a perspective view illustrating a portion of a circuit board unit housed in the electronic device.
[FIG. 11B]

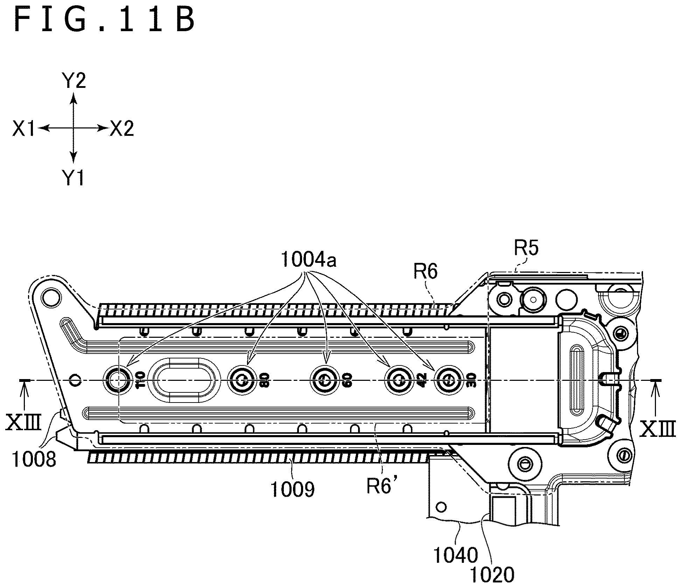

   FIG. 11B is a plan view illustrating a portion of the circuit board unit.
[FIG. 12A]

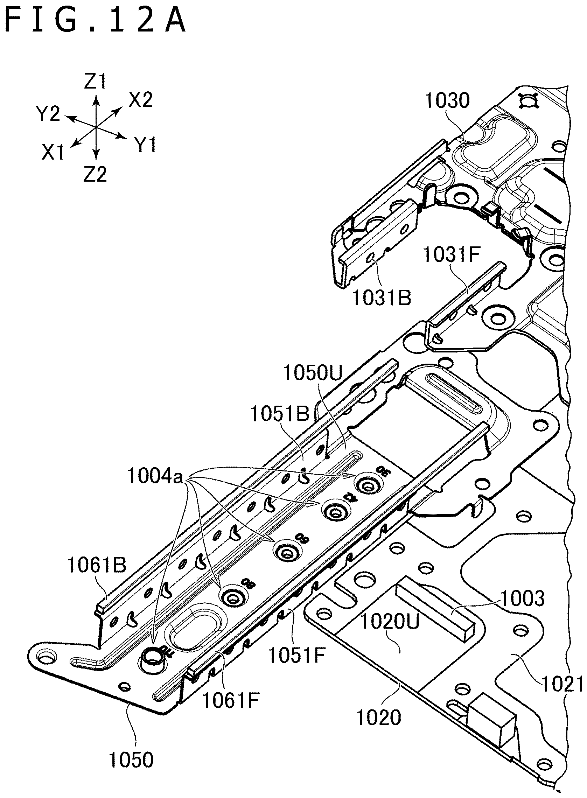

   FIG. 12A is an exploded perspective view illustrating the portion of the circuit board unit in a disassembled state.
[FIG. 12B]

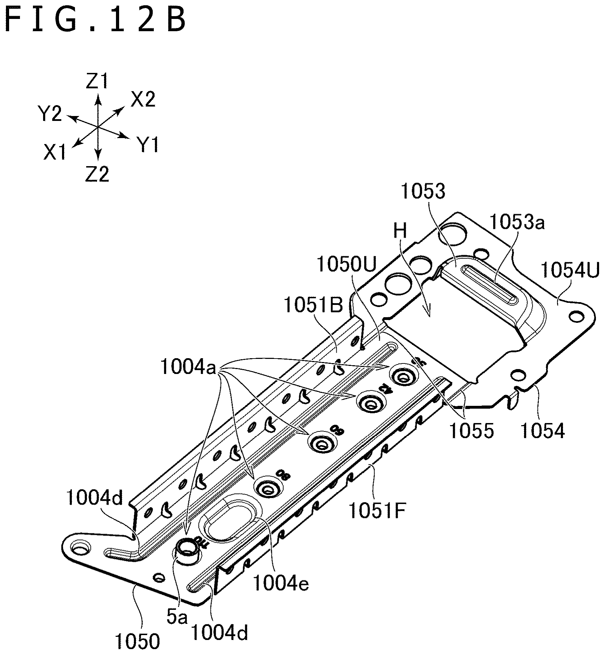

   FIG. 12B is a perspective view of a connector shield.
[FIG. 13A]

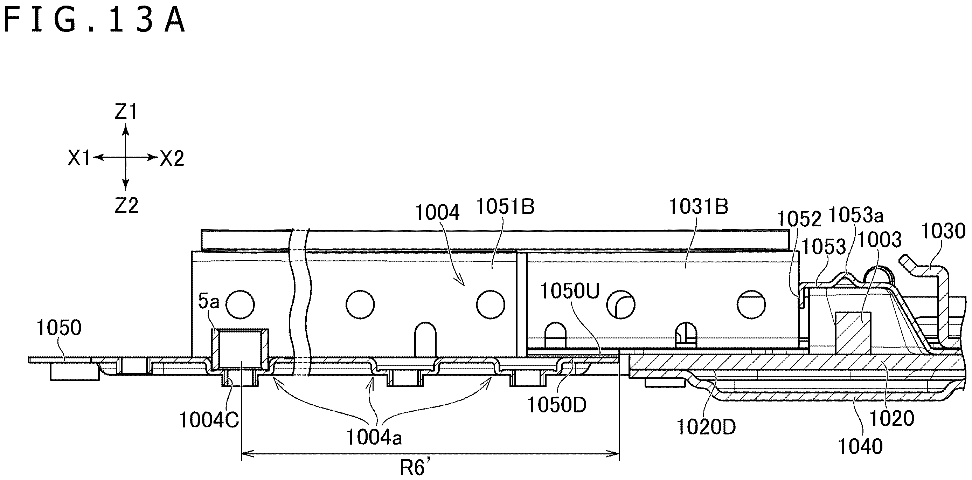

   FIG. 13A is a cross-sectional view of the circuit board unit obtained by a cross-sectional view including line XIII-XIII of FIG. 11B.
[FIG. 13B]

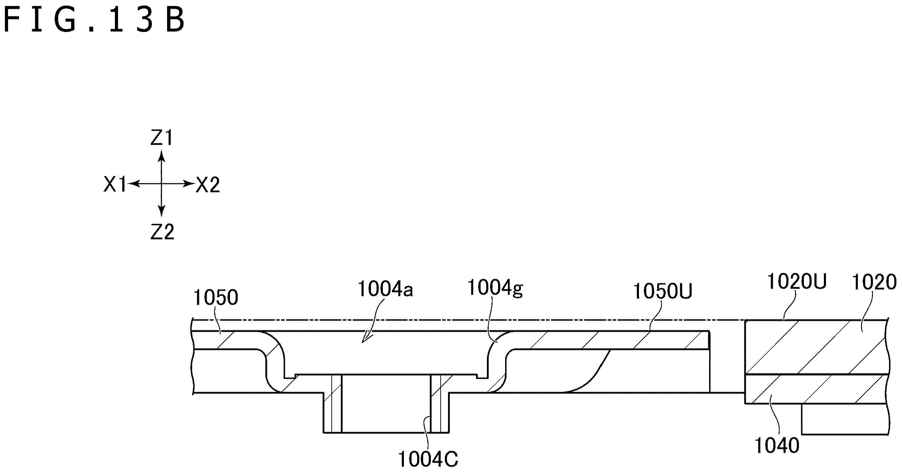

   FIG. 13B is an enlarged view of a portion of the cross-sectional view of FIG. 13A.

### [Description of Embodiment]

### [1. First embodiment]

### [1-1. Overview of electronic device]

FIG. 1A is a perspective view illustrating an electronic device 1 that is an example of an embodiment of the present disclosure, and FIG. 1B is a plan view of the electronic device 1. FIGS. 1A and 1B illustrate a state in which a cover not illustrated has been removed from the electronic device 1. FIGS. 1C and 1D are perspective views illustrating a housing chamber 4 of the electronic device 1 in which a storage medium 100 is to be housed. FIGS. 1B to 1D illustrate a state where a memory cover 60 has been removed from the electronic device.

As illustrated in FIG. 1A, connectors 3a and 3b are formed on a side surface 1R of the electronic device 1. The connectors 3a and 3b are, for example, connectors conforming to the universal serial bus (USB) standard, but the standard of them is not limited to the USB standard.

In the following description, a Z1 direction (a direction in which the housing chamber 4 to be described later opens) and a Z2 direction of a Z axis illustrated in FIG. 1A and other figures are referred to as an upward direction and a downward direction, respectively. Also, a Y1 direction and a Y2 direction of a Y axis perpendicular to the Z axis are referred to as a forward direction and a backward direction, respectively. Also, an X1 direction and an X2 direction of an X axis perpendicular to the Z axis and the Y axis are referred to as a rightward direction and a leftward direction, respectively. However, these directions are defined to describe shapes and relative positional relations of elements such as components, members, and portions of the electronic device 1 and do not limit the posture of the electronic device 1 during use. For example, when the electronic device 1 is in use, the electronic device 1 may be placed on a ground surface such as a floor surface while its upward and downward directions are being reversed, or may be placed with its side surface (a surface in the X2 direction) held in contact with the ground surface.

As indicated by a two-dot chain line in FIG. 1B, a storage medium 100 such as a solid state drive (SSD) is attached inside the electronic device 1. As illustrated in FIGS. 1B to 1D, the electronic device 1 is provided with the housing chamber 4 that is a recess for housing the storage medium 100. As illustrated in FIG. 1B, according to the present embodiment, the housing chamber 4 is disposed in front of a cooling fan 1F. According to the present embodiment, the housing chamber 4 is disposed between the cooling fan 1F and the connectors 3a and 3b in the forward and backward directions.

### [1-2. Housing structure of storage medium]

FIG. 2 is a cross-sectional view of the electronic device 1 obtained by a cross-sectional view including line II-II of FIG. 1B and illustrates a state in which the storage medium 100 and the memory cover 60 are attached to the electronic device 1. FIG. 3A is a plan view of a circuit board unit 10 housed inside the electronic device 1. FIG. 3B is an exploded perspective view illustrating constituent elements of the circuit board unit 10. As illustrated in FIG. 2, a circuit board 20 has an upper surface 20U (first surface) facing upward (in a first direction) and a lower surface 20D facing downward (in a second direction opposite to the first direction). The housing chamber 4 housing the storage medium 100 is a box-shaped space having a bottom portion which is defined by an upper surface 40U (third surface) of a lower board shield 40 to be described later and the upper surface 20U of the circuit board 20, as illustrated in FIG. 3B, and three walls standing on the front side, back side, and right side of the bottom portion. The cover 60 is attached to a housing 70 forming at least part of the housing chamber 4 and covers the housing chamber 4 on the upper side, thereby closing the housing chamber 4.

As illustrated in FIG. 2, the memory cover 60 that covers the housing chamber 4 is fixed to the housing 70 made of an insulating material such as resin, by means of a fixture 6 such as a screw. Below the housing 70, the lower board shield 40 that covers the lower side of the circuit board 20 is placed, and the fixture 6 passes through a mounting hole 72 formed in the housing 70 and is attached to a mounting hole 42 formed in the lower board shield 40. The memory cover 60, the fixture 6, and the lower board shield 40 are each made of conductive metal, and these members are electrically connected to each other.

Moreover, as illustrated in FIG. 2, the storage medium 100 is housed inside the housing chamber 4 covered with the memory cover 60. Incidentally, a sponge-like cushion member may be provided between the memory cover 60 and the storage medium 100 to protect the storage medium 100 from impact or the like, or a heat sink may be provided to cool the storage medium 100.

As illustrated in FIG. 2, the storage medium 100 has a circuit board 101. The storage medium 100 has areas 102U and 102D in which an integrated circuit mounted on the circuit board 101 and a heat dissipation component and the like attached to the integrated circuit are arranged. Further, the storage medium 100 has a first end 100L and a second end 100R located opposite to the first end 100L. A terminal part not illustrated is formed at the first end 100L of the storage medium 100. In addition, a ground part not illustrated is formed at the second end 100R of the storage medium 100. The circuit board 101 of the storage medium 100 has the first end 100L and the second end 100R. The terminal part and the ground part are conductive wiring or the like mounted on the circuit board 101. The first end 100L and the second end 100R of the circuit board 101 protrude in longitudinal directions (X2 direction and X1 direction) of the storage medium 100 beyond the areas 102U and 102D where the integrated circuit and the like are arranged. In the following description, the first end 100L is also simply referred to as the end 100L, and the second end 100R is also simply referred to as the end 100R.

As illustrated in FIG. 1C, a connector 3c is provided inside the housing chamber 4 that houses the storage medium 100. As illustrated in FIG. 2, the connector 3c is provided at one end (the left end) of the housing chamber 4. The connector 3c is fitted with the end 100L (see FIG. 2) of the storage medium 100 and electrically connected to the terminal part provided on the end 100L. Although the storage medium 100 and the connector 3c are, for example, designed according to the M.2 standard, the standard of the storage medium 100 and the connector 3c is not necessarily limited to the M.2 standard. The bottom portion of the housing chamber 4 facing the storage medium 100 attached to the connector 3c is constituted by the upper surface 20U of the circuit board 20 in the vicinity of the connector 3c, and by the upper surface 40U of the lower board shield 40 (a member different from the circuit board 20) in the remaining portion.

As illustrated in FIG. 1D, a hollow cylindrical spacer 5a is attached inside the housing chamber 4 that houses the storage medium 100. The spacer 5a is attachable to and detachable from the member different from the circuit board 20. According to the present embodiment, the spacer 5a is attachable to and detachable from the lower board shield 40 (circuit board shield) to be described later that makes up the inside of the housing chamber 4. As illustrated in FIG. 2, a fixture 5b such as a screw or a rivet is mounted on the end 100R of the storage medium 100, the spacer 5a, and the lower board shield 40 as a member different from the circuit board 20, fixing these parts.

The spacer 5a and the fixture 5b function as a support structure 5 that supports the end 100R of the storage medium 100 in the housing chamber 4. As illustrated in FIG. 2, the spacer 5a supports the end 100R (second end) of the storage medium 100. According to the present embodiment, the spacer 5a is arranged on the lower board shield 40 forming the housing chamber 4 and makes contact with both the end 100R of the storage medium 100 and the lower board shield 40 at a position between the end 100R of the storage medium 100 and the lower board shield 40. The spacer 5a secures a distance between the end 100R of the storage medium 100 and the lower board shield 40. The fixture 5b fixes the end 100R of the storage medium 100 to a mounting hole 4c formed in the housing chamber 4.

Accordingly, the support structure 5 can support the storage medium 100 and fix the storage medium 100 inside the housing chamber 4.

Further, the member different from the circuit board 20 has at least one positioning portion that defines the position of the spacer 5a. According to the present embodiment, at least one positioning portion 4a that defines the position of the spacer 5a is formed on the lower board shield 40. The positioning portion 4a is formed on a surface (third surface, the upper surface 40U illustrated in FIG. 3) of the lower board shield 40. As illustrated in FIG. 1D, the lower board shield 40 that makes up the housing chamber 4 has a plurality of positioning portions 4a arranged in rightward and leftward directions (directions along the X axis). This makes it possible to support a plurality of kinds of storage media 100 having different sizes in the rightward and leftward directions with the support structure 5 and fix them inside the housing chamber 4. In the example illustrated in FIG. 1D, the lower board shield 40 has the plurality of positioning portions 4a formed at predetermined intervals in longitudinal directions of the housing chamber 4. Depending on the size of the storage medium 100, either one of these positioning portions 4a is selected, and the spacer 5a is attached to the inside of a region R1 defined by the selected positioning portion 4a.

Each positioning portion 4a formed on the lower board shield 40 is formed integrally with the upper surface 40U of the lower board shield 40 by sheet-metal processing of the lower board shield 40. In the example illustrated in FIG. 1D, each positioning portion 4a includes a plurality of guide protrusions 4b surrounding the region R1 in which the spacer 5a is to be disposed. One positioning portion 4a includes three guide protrusions 4b, and the distance between the guide protrusions 4b included in one positioning portion 4a is smaller than a diameter of a circle defined by an outer edge of the spacer 5a. Hence, the two or more guide protrusions 4b can make contact with the outer edge of the spacer 5a to guide the spacer 5a to the region R1, thereby facilitating the arrangement of the spacer 5a in the housing chamber 4. Moreover, the spacer 5a can be prevented from moving to the outside of the region R1 defined by the three guide protrusions 4b.

Note that the number of guide protrusions 4b surrounding the region R1 where the spacer 5a is to be disposed may be two or four. In the case where the number of guide protrusions 4b is two, each of the guide protrusions 4b may surround the region R1 where the spacer 5a is to be disposed, in an arcuate manner in plan view. Also, the number of guide protrusions 4b surrounding the region R1 may be one. In this case, the guide protrusion 4b may surround the region R1 with an arc having a central angle of 180 degrees or more or a full circle in plan view.

As illustrated in FIG. 1D, the mounting hole 4c is formed in a central position of the region R1 defined by the positioning portion 4a. At least one guide protrusion 4b (a plurality of guide protrusions 4b in the example illustrated in FIG. 1D) included in each positioning portion 4a is formed along an outer edge of the mounting hole 4c. As illustrated in FIG. 2, the fixture 5b such as a screw or a rivet is mounted in a hole formed in the spacer 5a and the mounting hole 4c formed in the lower board shield 40.

The fixture 5b is made of a conductive material such as metal and is electrically connected to the ground part of the storage medium 100 by coming into contact with the ground part such as a ground pattern mounted on the end 100R of the storage medium 100. For example, the ground part is formed on the upper surface of the circuit board 101, and a head portion of the screw, which is the fixture 5b, is electrically connected to the ground part. The fixture 5b is in contact with the lower board shield 40 made of a conductive material such as iron or aluminum, at a lower end thereof fitted in the mounting hole 4c, thereby electrically connecting the ground part of the storage medium 100 with the lower board shield 40. Also, the spacer 5a may be made of a conductive material. The end 100R of the circuit board 101 is sandwiched between the head portion (upper end) of the fixture 5b and an upper end of the spacer 5a, and the spacer 5a makes contact with both the ground part of the storage medium 100 and the lower board shield 40, so that the ground part of the storage medium 100 and the lower board shield 40 may electrically be connected.

As illustrated in FIGS. 1C and 1D, the lower board shield 40 forming the housing chamber 4 is formed with protective protrusions 4d that protrude upward to a position higher than the guide protrusions 4b. On the lower board shield 40, the protective protrusions 4d extend in the longitudinal directions of the housing chamber 4, namely, in the rightward and leftward directions (directions along the X-axis). The protective protrusions 4d are formed on the front and back sides of the plurality of positioning portions 4a arranged in the rightward and leftward directions. The protective protrusions 4d prevent the guide protrusions 4b from interfering with the end 100L of the storage medium 100 or components on the storage medium 100 when the end 100L of the storage medium 100 is being attached to the connector 3c. By forming the protective protrusions 4d, the end 100L of the storage medium 100 can be slid leftward while the components mounted on the circuit board 101 of the storage medium 100 are in contact with the protective protrusions 4d, and the end 100L can be fitted into the connector 3c.

Further, as illustrated in FIG. 1D, a protrusion 4e protruding upward is formed on the lower board shield 40 constituting the housing chamber 4. The protrusion 4e forms a hole 4f having an opening that faces in the leftward direction along the circuit board 20 (X2 direction), namely, in the direction of the connector 3C. By doing so, the storage medium 100 housed in the housing chamber 4 can be cooled by air flowing from the opening of the hole 4f. Further, by forming the hole 4f by using the protrusion 4e, the opening of the hole 4f faces leftward, and the height of the opening can be reduced while securing the area of the opening of the hole 4f. Accordingly, a component (for example, the spacer 5a) can be prevented from falling into the hole 4f. The mounting hole 4c formed in the lower board shield 40 also forms an air flow path for cooling the storage medium 100.

As illustrated in FIG. 3B, the circuit board unit 10 has the circuit board 20, an upper board shield 30, the lower board shield 40, and a connector shield 50. The upper board shield 30 covers the upper surface 20U of the circuit board 20. The lower board shield 40 covers the lower surface 20D of the circuit board 20. The connector 3c and a connector 3d which will be described later are mounted on the upper surface 20U of the circuit board 20. The connector shield 50, together with the upper board shield 30, covers the upper surface 20U of the circuit board 20. The connector shield 50 covers the connectors 3c and 3d mounted on the upper surface 20U of the circuit board 20.

As illustrated in FIG. 3B, a plurality of electronic components such as integrated circuit chips 21 are mounted on the upper surface 20U of the circuit board 20. A plurality of electronic components are also mounted on the lower surface 20D of the circuit board 20. The upper board shield 30 and the lower board shield 40 are provided for suppressing leakage of noise such as electromagnetic waves generated from the plurality of electronic components mounted on the circuit board 20 to the outside of the circuit board unit 10. The upper board shield 30 and the lower board shield 40 can be manufactured by performing sheet-metal processing such as drawing processing on a conductive metal plate such as iron or aluminum. The upper board shield 30 and the lower board shield 40 are fixed to the circuit board 20 by a plurality of screws, rivets, or the like.

Incidentally, in the example illustrated in FIG. 3B, a heat pipe 8U and a heat sink 9U are attached to the upper board shield 30, and a heat pipe 8D and a heat sink 9D are attached to the lower board shield 40. The heat pipe 8D and the heat sink 9D are attached to the lower side of the lower board shield 40.

FIG. 3C is a perspective view illustrating part of the circuit board unit 10 and illustrates a periphery of the connector 3c mounted on the upper surface 20U of the circuit board 20. As illustrated in FIG. 3C, the connector 3c to which the end 100L of the storage medium 100 is to be attached is mounted on the upper surface 20U of the circuit board 20. The at least one positioning portion 4a is disposed outside of an outer edge of the circuit board 20 and positioned in a direction (the X1 direction) along the circuit board 20 with respect to the connector 3c. The support structure 5 for the storage medium 100 including the spacer 5a and the fixture 5b is thus disposed outside of the outer edge of the circuit board 20 and in the direction along the circuit board 20 with respect to the connector 3c. As illustrated in FIG. 3A, the lower board shield 40 has an outer region R2 located outside the outer edge of the circuit board 20, and the support structure 5 is provided in the outer region R2. The lower board shield 40 is electrically connected to the ground part of the storage medium 100 via the support structure 5 located in the outer region R2.

In a related-art electronic device, the ground part of the storage medium 100 is connected to a ground pattern formed on a circuit board via the support structure 5 including the spacer 5a and the fixture 5b. In contrast, in the present embodiment, the ground part of the storage medium 100 makes contact with and is electrically connected to the lower board shield 40, which is a member different from the circuit board 20, through the support structure 5. By doing so, formation of the ground pattern on the circuit board 20 can be omitted, and the cost of the circuit board 20 can be reduced.

In addition, a part that electrically connects to the ground part of the storage medium 100 via the support structure 5 (for example, the mounting hole 4c to which the fixture 5b is attached or the region R1 where the spacer 5a is disposed) is provided on the lower board shield 40, so that the housing chamber 4 for housing the storage medium 100 can be formed by performing sheet-metal processing on the lower board shield 40. That is, formation of the housing chamber 4 can be facilitated. In addition, for example, the number of members required for manufacturing the electronic device 1 can be reduced compared to the case where the housing chamber 4 is formed of a member different from the constituent elements of the circuit board unit 10.

As illustrated in FIG. 2, an upper end (an end in the first direction) of the at least one positioning portion 4a is disposed lower (in the second direction) than the upper surface 20U (the first surface) of the circuit board 20. According to the present embodiment, the guide protrusion 4b of each positioning portion 4a has a top portion formed lower than the upper surface 20U (an extension of the upper surface 20U indicated by a two-dot chain line in the cross-sectional view of FIG. 2) of the circuit board 20.

By thus providing the positioning portion 4a that defines the position of the spacer 5a on the member different from the circuit board 20, the circuit board 20 can be made smaller in size, increasing the degree of freedom of the size and layout of the circuit board 20, compared with the case of providing the positioning structure for the spacer 5a on the circuit board 20. Moreover, a space is secured below the storage medium 100 by positioning the upper end of each positioning portion 4a lower than the upper surface 20U of the circuit board 20. This allows the degree of freedom of the size and layout of components such as integrated circuits mounted on the storage medium 100 to be increased in the region 102D below the storage medium 100.

As illustrated in FIG. 3A, the outer region R2 of the lower board shield 40 that is located outside the outer edge of the circuit board 20 includes a placement area R2' where the storage medium 100 is to be placed. The placement area R2' represents an area defined along the outer edge of the storage medium 100 with the terminal part attached to the connector 3c (see FIG. 2). The placement area R2' of the lower board shield 40 confronts the storage medium 100 that is connected to the connector 3c, and is commensurate with the size of the storage medium 100. As viewed in plan, the size and shape of the placement area R2' coincide with the size and shape of the portion of the connector 100 that includes at least the end 100R. The at least one positioning portion 4a may be provided inside of the placement area R2'.

As illustrated in FIG. 2, the upper surface 40U (third surface) of the lower board shield 40 where the at least one positioning portion 4a is formed is provided lower than the upper surface 20U (an extension of the upper surface 20U indicated by the two-dot chain line in the cross-sectional view of FIG. 2) of the circuit board 20. In the lower board shield 40, the placement area 2' where the storage medium 100 is placed is provided lower than the upper surface 20U of the circuit board 20. More specifically, the placement area 2' is provided in its entirety lower than the upper surface 20U of the circuit board 20. This arrangement allows a desired structure (e.g., a structure required to mount the storage medium 100) to be provided in an area (e.g., the placement area 2') overlapping the storage medium 100 on the upper surface 40U of the lower board shield 40. Moreover, since a space can be secured below the storage medium 100, the degree of freedom of the size and layout of components such as integrated circuits mounted on the storage medium 100 can be increased in the region 102D below the storage medium 100.

As illustrated in FIG. 3C, the lower board shield 40 has a wall 41F standing along a front side portion (Y1 side portion) of the storage medium 100, a wall 41B standing along a back side portion (Y2 side portion) of the storage medium 100, and a wall 41R standing along the end 100R. The housing chamber 4 for housing the storage medium 100 is formed into a box shape having the bottom portion defined by the upper surface 40U of the lower board shield 40 and the upper surface 20U of the circuit board 20, and the walls 41F, 41B, and 41R of the lower board shield 40 surrounding the bottom portion. The walls 41F, 41B, and 41R may be formed by subjecting the lower board shield 40 to sheet-metal processing such as bending.

As illustrated in FIG. 3C, the upper board shield 30 also has 31BL and 31BR standing along the back side portion (Y2 side portion) of the storage medium 100 and 31F standing along the front side portion (Y1 side portion) of the storage medium 100. The walls 31F, 31BL, and 31BR together with the walls 41F, 41B, and 41R of the lower board shield 40 form the box-shaped housing chamber 4. That is, the housing chamber 4 is formed of different components. The walls of the housing chamber 4 standing along the sides of the storage medium 100 are configured in such a manner that a portion along an edge of the circuit board 20 is constituted by the upper board shield 30 and the remaining portion is constituted by the lower board shield 40.

As illustrated in FIG. 3C, a clearance C1 is formed between the walls 41B and 31BR standing along the back side portion (Y2 side portion), among the walls on the front side and the back side of the storage medium 100. Further, a clearance C2 is formed between the walls 31BR and 31BL, and a clearance C3 is formed between the wall 31BL and the connector shield 50. As illustrated in FIGS. 1C and 1D, walls 71 of the housing 70 are arranged in the clearances C1 to C3. The walls 71 are used for fixing the circuit board unit 10 to the housing 70, for example.

The housing chamber 4 that houses the storage medium 100 includes the circuit board 20 and the member different from the circuit board 20. As described above, the bottom portion of the housing chamber 4 is constituted by the upper surface 20U of the circuit board 20 in the vicinity of the connector 3c, and by the lower board shield 40 covering the circuit board 20 in the remaining portion. By doing so, the cost of the circuit board 20 can be reduced compared to the case where the entire bottom portion of the housing chamber 4 is constituted by the circuit board 20. Incidentally, at least part of the bottom portion of the housing chamber 4 may be constructed by the upper board shield 30.

### [1-3. Structure of connector shield]

As illustrated in FIG. 3B, the connector 3d (first connector) is mounted on the upper surface 20U of the circuit board 20 (first circuit board). Further, the upper board shield 30 covers the circuit board 20, and an outer edge of the upper board shield 30 is formed in such a manner as to avoid the connector 3d. That is, in an assembled state of the circuit board unit 10, the connector 3d is exposed in a region R3 defined outside the outer edge of the upper board shield 30 (see FIG. 3B). The connector shield 50 covers the connector 3d mounted on the upper surface 20U of the circuit board 20 in the region R3. Further, the connector 3c (third connector) to which the above-described storage medium 100 is to be connected is mounted on the upper surface 20U of the circuit board 20. The outer edge of the upper board shield 30 is formed in such a manner as to avoid the connector 3c as well, and the connector 3d is exposed when the circuit board unit 10 is assembled. The connector shield 50 covers the connector 3c as well as the connector 3d.

The connector shield 50 can be manufactured by performing sheet-metal processing such as drawing processing on a conductive metal plate such as iron or aluminum. As illustrated in FIG. 3C, the connector shield 50 has a recess 57 having a dent upward at a position corresponding to the connector 3d. The connector 3d and an end 91 of a flexible flat cable (FFC) 90 attached thereto are housed inside the recess 57.

As illustrated in FIG. 3C, a bend 58 that is bent downward is formed on an edge of the connector shield 50. The bend 58 of the connector shield 50 abuts against the edge of the upper board shield 30 or the edge of the circuit board 20. This facilitates positioning of the connector shield 50 with respect to the upper board shield 30. Further, the connector shield 50 has a guide hole 59 at a position different from the recess 57, and the upper board shield 30 has a guide protrusion 39 projecting upward at a position corresponding to the guide hole 59 of the connector shield 50. When the connector shield 50 is disposed on the upper board shield 30, the guide protrusion 39 of the upper board shield 30 passes through the guide hole 59 of the connector shield 50. This also facilitates positioning of the connector shield 50 with respect to the upper board shield 30.

FIG. 3D is a perspective view illustrating part of the circuit board 20 and illustrates the periphery of the connectors 3c and 3d mounted on the upper surface 20U of the circuit board 20. The connector 3d illustrated in FIG. 3D is a connector that is fitted to the end 91 of the FFC 90 to be described later and electrically connected to the FFC 90. The connector 3d has a locking mechanism for fixing the end 91 of the FFC 90 to the connector 3d. For example, the locking mechanism of the connector 3d includes a lever Le, and by an operator moving the lever Le to a predetermined fixing position, the end 91 of the FFC 90 is fixed inside the connector 3d. Further, by the operator moving the lever Le to a predetermined release position, the fixation of the connector 3d to the end 91 of the FFC 90 is released. As illustrated in FIGS. 3C and 3D, the connector shield 50 covers the locking mechanism including the lever Le of the connector 3d. The connector shield 50 covers the entire connector 3d.

FIG. 4 is a cross-sectional view of the electronic device 1, obtained by a cross section along line IV-IV in FIG. 3A. Part of the electronic device 1 is omitted in FIG. 4.

As illustrated in FIG. 3D and 4, a conductive elastic member 110 is mounted on the end 91 of the FFC 90. The elastic member 110 is in contact with both a ground pattern, not illustrated, provided at the end 91 of the FFC 90 and the connector shield 50. Further, as illustrated in FIG. 4, the electronic device 1 has a circuit board 80 (second circuit board). A connector 3e (second connector) connected to the connector 3d via the FFC 90 is mounted on the circuit board 80. The circuit board 80 is arranged on the front side (left side in FIG. 4) of the circuit board 20 and arranged along a plane perpendicular to the upper surface 20U and the lower surface 20D of the circuit board 20. The circuit board 80 is mounted with the connectors 3a and 3b illustrated in FIG. 1A.

As illustrated in FIG. 3C, the connector shield 50 is attached to and removable from the upper board shield 30 by using fixtures 7 such as screws. The connector shield 50 has fixing portions 51 such as holes, to be fixed to the upper board shield 30. Further, the upper board shield 30 has fixing portions 32 (see FIG. 3B) such as holes, to be fixed to the connector shield 50 and the circuit board 20, and the circuit board 20 has fixing portions 22 (see FIG. 3D), to be fixed to the upper board shield 30. As illustrated by dashed-dotted straight lines L1 in FIG. 3B, the fixing portions 22, 32, and 51 are aligned in vertical directions, and one fixture 7 is passed through the corresponding fixing portions 22, 32, and 51 so as to fix the connector shield 50 and the upper board shield 30 to the circuit board 20.

In a related-art structure, the connector 3d is covered with the upper board shield 30 that widely covers the circuit board 20, and when the FFC 90 is removed from the connector 3d for repairing the electronic device 1 or the like, the upper board shield 30 needs to be removed. Since the upper board shield 30 is fixed to the circuit board 20 by screws or the like at multiple positions, the work of removing the upper board shield 30 is complicated. In this respect, since the connector 3d is covered with the connector shield 50 different from the upper board shield 30, the FFC 90 can be removed from the connector 3d by removing only the connector shield 50 without removing the upper board shield 30. In other words, provision of the connector shield 50 facilitates removal of the FFC 90 from the connector 3d.

As illustrated in FIG. 3D, a ground pattern 23 is formed on the upper surface 20U of the circuit board 20 by using a conductive material. The fixing portions 22 to be fixed to the fixing portions 32 of the upper board shield 30 are formed on the ground pattern 23. By fastening the corresponding fixing portions 22 and 32 to each other with one fixture 7 (see FIG. 3C), the upper board shield 30 makes contact with the ground pattern 23 on the circuit board 20 at the position of the fixing portions 22 and 32.

Protrusions 24 protruding upward are formed on the ground pattern 23 formed on the circuit board 20. When the protrusions 24 make contact with the upper board shield 30, noise leakage can more effectively be suppressed. One or two protrusions 24 are formed between two adjacent fixing portions 22 formed on the ground pattern 23. The distances between the fixing portion 22 and the protrusion adjacent to each other and between two adjacent protrusions may be set to less than 1/3 of a wavelength of noise shielded by the upper board board shield 30, and more preferably, less than 1/4 of the wavelength. For example, the distances between the fixing portion 22 and the protrusion adjacent to each other and between the two adjacent protrusions are set to 20 mm or less, more preferably, 15 mm or less or 10 mm or less, so that leakage of noise of a frequency band desired to be shielded can effectively be suppressed.

In this manner, leakage of noise such as electromagnetic waves generated from electronic components mounted on the upper surface 20U of the circuit board 20 to the outside of the circuit board unit 10 can be suppressed at the positions of the fixing portions 22 and 32 and the protrusions 24. In particular, the noise of the electronic components mounted on the circuit board 20 on an inner side with respect to the ground pattern 23 on the upper surface 20U of the circuit board 20 is shielded by the upper board shield 30, and leakage of noise to the region R3 where the connector 3d is mounted and the area where the connector 3c is mounted is effectively reduced as well.

Further, one fixing portion 51 of the connector shield 50 is fixed by one fixture 7 to the corresponding fixing portions 22 and 32 to which noise countermeasures have been applied. In this manner, by fixing the connector shield 50 by using the fixtures 7 for fixing the upper board shield 30 and the ground pattern 23, the number of fixtures 7 required for the circuit board unit 10 can be reduced.

Further, as illustrated in FIG. 3B, the circuit board unit 10 has a region R4 on which electronic components such as integrated circuits on the circuit board 20 are arranged and which is surrounded by a ground part. An outer edge of the region R4 is constituted by the ground pattern 23 of the circuit board 20, for example. Still further, part of the outer edge of the region R4 may be formed by contact portions between a left edge 40L and a right edge 40R of the lower board shield 40 and a left edge 30L and a right edge 30R of the upper board shield 30 illustrated in FIG. 3B. In this manner, noise countermeasures are taken for the electronic components arranged in the region R4.

As illustrated in FIG. 3D, the connector shield 50 is arranged outside the region R4 defined on the circuit board 20 in plan view. By adopting the above layout, leakage of noise to the outside of the region R4 defined on the circuit board 20 can be suppressed, and the FFC 90 can be removed from the connector 3d by removing only the connector shield 50. In addition, by fixing the fixing portions 51 of the connector shield 50 by using the plurality of fixtures 7 attached to the fixing portions 22 and 32 for noise countermeasures, the number of fixtures 7 used in the circuit board unit 10 can further be reduced.

Further, on the upper surface 20U of the circuit board 20, noise generated from electronic components mounted inside the region R4 defined by the ground pattern 23 is shielded by the upper board shield 30. Therefore, the connector shield 50 that can be attached to and detached from the circuit board 20 and the upper board shield 30 can adopt a shape obtained by taking account of countermeasures against noise generated from the connector 3c or the connector 3d or a shape obtained by taking account of attachment to and detachment from the circuit board 20 or the like. Accordingly, the structure of the connector shield 50 can be simplified.

### [1-4. Structure for countermeasures against static electricity]

FIG. 5 is an enlarged view of part of the cross section illustrated in FIG. 2 and illustrates the periphery of the connector 3c mounted on the upper surface 20U of the circuit board 20. As illustrated in FIG. 5, the connector 3c has a fitting recess 301 for fitting the end 100L of the storage medium 100 therein. The fitting recess 301 opens in the rightward direction along the circuit board 20 (first direction, or direction away from the connector 3c). The connector 3c is positioned on one end side (left side) of the housing chamber 4, and the fitting recess 301 opens toward the housing chamber 4.

FIG. 6 is a front view of the connector viewed in a direction of arrow A in FIG. 5 and illustrates the inside of the fitting recess 301 formed in the connector 3c. As illustrated in FIG. 6, the connector 3c has a plurality of first signal terminals 302 and a plurality of second signal terminals 304 for electrical connection of the storage medium 100, inside the fitting recess 301. As illustrated in FIG. 5, each first signal terminal 302 has a terminal part 302a that makes contact with a terminal part provided on the end 100L of the storage medium 100. Further, as illustrated in FIG. 6, each second signal terminal 304 also has a terminal part 304a that makes contact with a terminal part of the storage medium 100. The terminal parts 302a of the plurality of first signal terminals 302 are arranged on the upper side of the fitting recess 301 and arranged in the forward and backward directions (directions along the Y-axis in FIG. 6). In addition, the terminal parts 304a of the plurality of second signal terminals 304 are arranged on the lower side of the fitting recess 301 and arranged in the forward and backward directions.

As illustrated in FIG. 6, the connector 3c has insulating portions 303 each located between two adjacent ones of the plurality of first signal terminals 302. The insulating portions 303 are made of an insulating material such as resin and cover the upper side of the plurality of first signal terminals 302. As illustrated in FIG. 5, a right end 303R of each insulating portion 303 protrudes rightward beyond the terminal parts 302a of the first signal terminals 302 (in an extending direction of the terminal parts 302a, or a direction opposite to a mounting direction of the end 100L of the storage medium 100 into the fitting recess 301). In other words, the right end 303R of each insulating portion 303 protrudes further toward the housing chamber 4 than the terminal parts 302a of the first signal terminals 302. Hence, the insulating portions 303 protect the terminal parts 302a of the first signal terminals 302.

As previously mentioned, the connector shield 50 is formed separately from the upper board shield 30 and is attached to the upper board shield 30. The connector shield 50 has a dome shape that opens toward the housing chamber 4 in such a manner as to expose the opening of the fitting recess 301 and that entirely covers other portions of the connector 3c. As illustrated in FIG. 6, the connector shield 50 has an electrostatic protecting portion 52 arranged along the opening of the fitting recess 301 of the connector 3c. In the present embodiment, the connector shield 50 functions as a ground member having the electrostatic protecting portion 52. A clearance C4 is formed between the connector 3c and the connector shield 50. The connector shield 50 constitutes the ground part of the circuit board unit 10 together with the ground pattern 23 of the circuit board 20, the upper board shield 30, the lower board shield 40, and the like. Therefore, the connector 3c is covered with a ground member different from the connector 3c.

As illustrated in FIG. 5, the electrostatic protecting portion 52 of the connector shield 50 is positioned on the right side (X1 direction) with respect to at least one of the plurality of first signal terminals 302 of the connector 3c. To be more specific, the electrostatic protecting portion 52 is positioned on the right side with respect to the terminal part 302a of the first signal terminal 302 that makes contact with the storage medium 100. The electrostatic protecting portion 52 may be positioned on the right side with respect to the right end of the entire first signal terminal 302. Also, the electrostatic protecting portion 52 may be positioned on the right side with respect to all of the plurality of first signal terminals 302 arranged on the upper side of the fitting recess 301. In other words, the electrostatic protecting portion 52 of the connector shield 50 is located closer to the housing chamber 4 than at least one of the plurality of first signal terminals 302 of the connector 3c. When an operator attaches or detaches the storage medium 100 to or from the connector 3c, the operator's finger moves from the housing chamber 4 toward the connector 3c together with the storage medium 100, so that static electricity can be conducted from the operator's finger to the electrostatic protecting portion 52 by providing the electrostatic protecting portion 52 on the housing chamber 4 side.

At least one of a plurality of electronic components such as the integrated circuit chips 21 (see FIG. 3B) mounted on the circuit board 20 functions as a controller that controls the storage medium 100. The controller mounted on the circuit board 20 is connected to the storage medium 100 via the connector 3c and controls input/output of signals to/from the storage medium 100. When replacing the storage medium 100, it is necessary to take measures to protect the connector 3c and the controller from static electricity generated on the operator's finger or the like.

In the circuit board 20, flow of static electricity to the controller can be suppressed, for example, by arranging a diode in an electrical path from the connector 3c to the controller. However, disposing an additional diode on the circuit board 20 is costly. In contrast, as in the present embodiment, a ground member such as the connector shield 50 having the electrostatic protecting portion 52 is provided, and the electrostatic protecting portion 52 is arranged at a position on the right side with respect to the first signal terminals 302 of the connector 3c, so that the static electricity can be received by the connector shield 50. As a result, there is no need to provide a diode in the electrical path leading to the controller, and the cost of the circuit board 20 can be reduced.

As illustrated in FIG. 5, the electrostatic protecting portion 52 of the connector shield 50 is positioned closer to the housing chamber 4 (rightward direction) than the right end 303R of the insulating portion 303 located between two adjacent first signal terminals 302. With this positional relation, it can be ensured that the electrostatic protecting portion 52 receives static electricity generated on the operator's finger or the like. The connector shield 50 conducts static electricity to the upper board shield 30 to which the connector shield 50 is attached.

As illustrated in FIG. 5, the housing 70 made of an insulating material such as resin has a first wall 73 that defines the housing chamber 4 for housing the storage medium 100. The first wall 73 defines an end of an inner surface of the housing chamber 4 close to the connector 3c. The electrostatic protecting portion 52 of the connector shield 50 protrudes rightward (X1 direction) further than the first wall 73 of the housing 70. The electrostatic protecting portion 52 of the connector shield 50 protrudes into the housing chamber 4. By doing so, the electrostatic protecting portion 52 can receive static electricity generated on the operator's finger or the like.

FIG. 7 is a cross-sectional view corresponding to FIG. 5 and illustrates a state obtained when the storage medium 100 is being mounted to the connector 3c. As illustrated in FIG. 7, the storage medium 100 can be moved in oblique directions (directions indicated by a dashed-dotted straight line L2) intersecting the rightward and leftward directions (first direction) and the vertical directions (second direction) in such a manner that the end 100L of the storage medium 100 is inserted into the opening of the fitting recess 301. The electrostatic protecting portion 52 of the connector shield 50 does not intersect the straight line L2 extending in the oblique directions passing through the fitting recess 301. The straight line L2 is, for example, a straight line parallel to a lower surface 301D of the fitting recess 301. By doing so, when the storage medium 100 is mounted to the connector 3c, while the electrostatic protecting portion 52 is prevented from interfering with the end 100L of the storage medium 100, the end 100L can be inserted into the fitting recess 301 in the oblique direction.

As illustrated in FIG. 5, a distance D1 from the electrostatic protecting portion 52 of the connector shield 50 to the deepest portion of the fitting recess 301 in the rightward and leftward directions is less than 5 mm. In general, a distance from an end face of the storage medium 100 (end face of the circuit board 101 facing in the X2 direction) to the component placement area 102U is greater than 5 mm. Therefore, by setting the distance D1 to be smaller than 5 mm, the electrostatic protecting portion 52 can be prevented from interfering with the component placement area 102U of the storage medium 100 while the end 100L of the storage medium 100 is inserted into the deepest portion of the fitting recess 301. More preferably, the distance D1 may be less than 4 mm. A tip (free end) of the electrostatic protecting portion 52 of the connector shield 50 is preferably located at a position between the right ends 303R of the insulating portions 303 and the end face, on the connector 3c side, of the component placement area 102U of the storage medium 100 attached to the connector 3c, in the longitudinal directions of the housing chamber 4.

The connector shield 50 has an upper wall 53 (first wall) that covers the plurality of first signal terminals 302 of the connector 3c. As illustrated in FIGS. 3C, 5, and 6, the connector shield 50 has a side wall 54 standing along a side of the connector 3c. The side wall 54 covers a front surface (Y1 side surface), a back surface (Y2 side surface), and a left side surface (X2 side surface) of the connector 3c where the opening of the fitting recess 301 is not formed.

In the connector shield 50, the electrostatic protecting portion 52 extends vertically (toward the upper surface 20U of the circuit board 20) from an end 53R of the upper wall 53 on the housing chamber 4 side in the rightward direction. The electrostatic protecting portion 52 is bent downward from the end 53R of the upper wall 53 toward the connector 3c. The tip of the electrostatic protecting portion 52 is preferably positioned above the right ends 303R of the insulating portions 303 in the vertical directions of the housing chamber 4, and is preferably placed at a low position within a range where the tip does not interfere with the storage medium 100 when the storage medium 100 is inserted or removed. Hence, the clearance C4 (distance) larger than a width D2 of the electrostatic protecting portion 52 in the vertical directions is secured between the upper wall 53 and the connector 3c. By securing the large clearance C4 between the connector 3c and the upper wall 53 in this manner, the static electricity received by the electrostatic protecting portion 52 can be allowed to flow through the upper wall 53 along a path away from the connector 3c. Incidentally, the clearance C4 between the upper wall 53 and the connector 3c may be equal to the width D2 of the electrostatic protecting portion 52 in the vertical directions. In other words, the distance of the clearance C4 may be a distance corresponding to the width D2 of the electrostatic protecting portion 52.

As illustrated in FIGS. 3C and 5, the upper wall 53 of the connector shield 50 has a projecting portion 53a protruding upward. As illustrated in FIG. 5, the housing 70 has a second wall 74 on the left side of the first wall 73. Further, a conductive elastic member 120 is housed in a space defined between the first wall 73 and the second wall 74 of the housing 70. The elastic member 120 is positioned above the upper wall 53 of the connector shield 50. The projecting portion 53a formed in the upper wall 53 makes contact with the elastic member 120.

As illustrated in FIG. 5, a right end 60R of the conductive memory cover 60 enters a clearance between the first wall 73 and the second wall 74 of the housing 70 and makes contact with the elastic member 120. The memory cover 60 is in contact with the elastic member 120 at the right end 60R and is electrically connected to the elastic member 120. Also, the connector shield 50 is in contact with the elastic member 120 at the projecting portion 53a and thus electrically connects with the elastic member 120 and the memory cover 60. In the case where static electricity is generated on a user's finger or the like when the memory cover 60 is attached or detached, static electricity is allowed to flow through the conductive elastic member 120 and the connector shield 50 to the upper board shield 30 to which the connector shield 50 is attached.

### [1-5. Summary]

As described above, in the present embodiment, the positioning portions 4a for positioning the spacer 5a are formed on the lower board shield 40 that is a member different from the circuit board 20. This makes it possible to make the circuit board 20 smaller in size, increasing the degree of freedom of the size and layout of the circuit board 20, compared with the case of providing the positioning structure for the spacer 5a on the circuit board 20.

According to the present embodiment, further, the upper surface 40U of the lower board shield 40 where each positioning portion 4a is formed is provided lower than the upper surface 20U of the circuit board 20. This allows a desired structure to be provided in a region (e.g., the placement area 2') overlapping the storage medium 100 on the upper surface 40U of the lower board shield 40.

According to the present embodiment, further, an upper end (an end in the first direction) of at least one positioning portion 4a is disposed lower than the upper surface 20U of the circuit board 20. More specifically, the top portion of the guide protrusion 4b of each positioning portion 4a is formed lower than the upper surface 20U of the circuit board 20. This arrangement secures a space below the storage medium 100, increasing the degree of freedom of the size and layout of components such as integrated circuits mounted on the storage medium 100, in the region 102D below the storage medium 100.

In addition, in the present embodiment, the ground part provided at the end 100R of the storage medium 100 makes contact with and electrically connects with the lower board shield 40, which is a member different from the circuit board 20, via the support structure 5 including the spacer 5a and the fixture 5b. Due to this, a structure for mounting the support structure 5 and establishing electrical connection via the support structure 5 can be omitted from the circuit board 20, and the cost of the circuit board 20 can be reduced.

Further, in the present embodiment, the connector 3d mounted on the upper surface 20U of the circuit board 20 is covered with the connector shield 50 different from the upper board shield 30. Due to this, the FFC 90 can be removed from the connector 3d by removing only the connector shield 50 without removing the upper board shield 30.

In addition, in the present embodiment, the connector shield 50 has the electrostatic protecting portion 52 arranged along the opening of the fitting recess 301 of the connector 3c to which the storage medium 100 is detachably connected. Due to this, in the case where static electricity is generated on the user's finger or the like when the storage medium 100 is attached or detached, the static electricity can be conducted to the connector shield 50 via the electrostatic protecting portion 52.

In addition, the present disclosure is not limited to the above embodiment.
(1) In the embodiment, the example in which the ground part of the storage medium 100 is electrically connected to the lower board shield 40 via the support structure 5 has been described. Alternatively, the ground part of the storage medium 100 may be electrically connected to a member different from the circuit board 20 and the lower board shield 40. For example, the ground part of the storage medium 100 may be electrically connected to the upper board shield 30. This can also omit the structure for attaching the support structure 5 or establishing electrical connection via the support structure 5 from the circuit board 20, and the cost of the circuit board 20 can be reduced.
(2) In the embodiment, the example in which the connector 3d connected to the end 91 of the FFC 90 is mounted on the upper surface 20U of the circuit board 20 has been described. Alternatively, the connector 3d may be mounted on the lower surface 20D (see FIG. 4) of the circuit board 20. In this case, the connector shield 50 may be attached to the lower board shield 40 and may cover the connector 3d exposed from the lower board shield 40 on the lower surface 20D of the circuit board 20. With such an arrangement, too, the FFC 90 can be removed from the connector 3d by removing only the connector shield 50 without removing the lower board shield 40, and the FFC 90 can easily be removed from the connector 3d.
(3) In the embodiment, the example in which the electrostatic protecting portion 52 that receives static electricity in the connector shield 50 is bent downward from the end 53R of the upper wall 53 has been described.

The shape of the connector shield 50 including the electrostatic protecting portion 52 is not limited to this example.

FIG. 8 is a perspective view illustrating part of the circuit board unit 10 according to a modification and illustrates a periphery of a connector shield 150 attached to the upper board shield 30. FIG. 9 is a cross-sectional view of the electronic device 1 around the connector shield 150. As illustrated in FIG. 8, the connector shield 150 is made of a conductive material and covers the connectors 3c and 3d, similarly to the connector shield 50 described in the above embodiment. However, in the connector shield 150, the shape of a portion covering the connector 3c is different from the shape described in the above embodiment.

As illustrated in FIG. 9, the connector shield 150 has an electrostatic protecting portion 152. Similarly to the example of the connector shield 50, the electrostatic protecting portion 152 is arranged along the opening of the fitting recess 301 of the connector 3c. The connector shield 150 has an upper wall 153 (first wall) covering the plurality of first signal terminals 302 of the connector 3c. The electrostatic protecting portion 152 is bent upward toward the side opposite to the connector 3c (upper side), from an end 153R of the upper wall 153 in the rightward direction.

The electrostatic protecting portion 152 of the connector shield 150 is positioned on the right side (X1 direction, or the housing chamber 4 side) with respect to the first signal terminals 302 mounted on the connector 3c. Further, a clearance D5 is formed between the upper wall 153 of the connector shield 150 and the connector 3c. Therefore, static electricity generated from a finger or the like of an operator approaching from the housing chamber 4 side can be received by the electrostatic protecting portion 52 and conducted to the connector shield 50.

Further, as illustrated in FIG. 9, the connector shield 150 includes a folded portion 154 extending leftward from an upper end of the electrostatic protecting portion 152 and a bend 155 bent obliquely upward from a left end of the folded portion 154. The connector shield 150 makes contact with the conductive elastic member 120 at the bend 155 and is electrically connected to the elastic member 120. Further, the memory cover 60 is in contact with the elastic member 120, and the connector shield 150 is electrically connected to the memory cover 6 via the elastic member 120.

(4) In the embodiment, the example in which the electrostatic protecting portion 52, which receives static electricity, is formed in the connector shield 50 has been described, but a part for receiving static electricity may be provided on a member different from the connector shield 50. As illustrated in FIG. 3C, the upper board shield 30 has the walls 31F and 31BL standing along the sides of the storage medium 100 housed in the housing chamber 4. Here, a conductive member (for example, a conductive tape) including a portion that receives static electricity may be attached to the walls 31F and 31BL of the upper board shield 30. Alternatively, the conductive member including the portion that receives static electricity may be attached to the lower board shield 40 or may be attached to the upper wall 53 of the connector shield 50 covering the connector 3c. With such an arrangement, too, static electricity can be conducted to the upper board shield 30 and the lower board shield 40 more quickly by arranging the portion that receives static electricity near an edge of the opening of the housing chamber 4.

### [2. Second embodiment]

FIG. 10 is a plan view illustrating a portion of an electronic device 1000 according to a second embodiment. As illustrated in FIG. 10, the electronic device 1000 also has a housing chamber 1004 that is a recess for housing therein a storage medium 100 such as an SSD. As illustrated in FIG. 10, the housing chamber 1004 may be disposed behind a cooling fan 2F. Incidentally, the housing chamber 1004 may be closed by a memory cover, not depicted. In the example illustrated in FIG. 10, a housing of the electronic device 1000 has a mounting hole 1072 formed therein for mounting therein a fixture 6 (see FIG. 2) such as a screw that fixes the memory cover to the housing.

FIG. 11A is a perspective view illustrating a portion of a circuit board unit 1010 housed in the electronic device 1000. FIG. 11B is a plan view illustrating a portion of the circuit board unit 1010. FIGS. 11A and 11B illustrate a portion of the circuit board unit 1010 where the housing chamber 1004 is formed.

FIG. 12A is an exploded perspective view illustrating the portion of the circuit board unit 1010 in a disassembled state. As illustrated in FIG. 12A, the circuit board unit 1010 has a circuit board 1020, an upper board shield 1030, and a connector shield 1050. The circuit board 1020 has an upper surface 1020U (first surface) facing upward (in a first direction) and a lower surface 20D (see FIG. 13A) facing downward (in a second direction opposite to the first direction). The upper board shield 1030 covers the upper surface 1020U of the circuit board 1020. Further, a connector 1003 is mounted on the upper surface 20U of the circuit board 1020. The connector shield 1050 is disposed between the upper board shield 1030 and the circuit board 1020, and the connector shield 1050 and the upper board shield 1030 cover a portion of the upper surface 1020U of the circuit board 1020. The connector shield 1050 covers the connector 1003 mounted on the upper surface 1020U of the circuit board 1020. The connector shield 1050 is illustrated by itself in perspective in FIG. 12B.

Further, the circuit board unit 1010 has a lower board shield 1040 (see FIG. 11A). The lower board shield 1040 covers the lower surface of the circuit board 1020. The upper board shield 1030 and the lower board shield 1040 may be something for restraining noise such as electromagnetic waves generated by a plurality of electronic components mounted on the circuit board 1020 from leaking out of the circuit board unit 1010. The upper board shield 1030 and the lower board shield 1040 may be made of an electrically conductive metal sheet of iron, aluminum, or the like processed by sheet-metal processing such as drawing processing. The upper board shield 1030 and the lower board shield 1040 may be fixed to the circuit board 1020 by a plurality of screws, rivets, or the like.

As illustrated in FIGS. 11A and 11B, heat pipes 1008 and a heat sink 1009 may be mounted on a lower side of the lower board shield 1040. The heat pipes 1008 receive heat from IC chips mounted on the circuit board 1020 and transfer the heat to the heat sink 1009. The heat sink 1009 dissipates the heat transferred thereto via the heat pipes 1008. Incidentally, in the exploded perspective view of FIG. 12A, the lower board shield 1040, the heat pipes 1008, and the heat sink 1009 are omitted from illustration.

As illustrated in FIG. 11A, the housing chamber 1004 that houses the storage medium 100 therein may include a bottom portion defined by an upper surface 1050U (third surface) of the connector shield 1050 and the upper surface 1020U of the circuit board 1020 and two walls standing in front of and behind the bottom portion. Further, elastic members 1061F and 1061B such as gaskets may be affixed to respective upper ends of the two walls.

FIG. 13A is a cross-sectional view of the circuit board unit 1010 obtained by a cross-sectional view including line XIII-XIII of FIG. 11B. In the cross section of FIG. 13, the heat pipes 1008 and the heat sink 1009 are omitted from illustration.

As illustrated in FIGS. 12A and 13A, the connector 1003 mounted on the circuit board 1020 is provided inside the housing chamber 1004. The connector 1003 is provided on an end (an end on the left side) of the housing chamber 1004. The connector 1003 is held in engagement with and electrically connected to a terminal part of the storage medium 100. The connector 1003 may be designed conforming to the M.2 standard, for example. The bottom portion of the housing chamber 1004 is made up of the upper surface 1020U of the circuit board 1020 in the vicinity of the connector 1003, whereas the remaining portion thereof is made up of the upper surface 1050U of the connector shield 1050 that is a member different from the circuit board 1020.

As illustrated in FIGS. 10 and 11A, a hollow cylindrical spacer 5a may be mounted inside the housing chamber 1004. The spacer 5a is attachable to and detachable from a member different from the circuit board 1020. According to the present embodiment, the spacer 5a is attachable to and detachable from the connector shield 1050 that makes up the bottom portion of the housing chamber 1004. The spacer 5a supports the end 100R (second end, see FIG. 2) of the storage medium 100, inside the housing chamber 1004. The spacer 5a is disposed between the end 100R of the storage medium 100 and the connector shield 1050 and held in contact with both the end 100R of the storage medium 100 and the connector shield 1050 at this position. The spacer 5a thus secures a distance between the storage medium 100 and the circuit board 1020 and a distance between the end 100R of the storage medium 100 and the connector shield 1050. Further, the end 100R of the storage medium 100, the spacer 5a, and the connector shield 1050 may be fixed by the fixture 5b (see FIG. 2) such as a screw or a rivet mounted thereon.

According to the present embodiment, too, the member different from the circuit board 1020 has at least one positioning portion 1004a for defining the position of the spacer 5a. According to the present embodiment, as illustrated in FIGS. 12A and 12B, the at least one positioning portion 1004a for defining the position of the spacer 5a is formed on the connector shield 1050. The positioning portion 1004a is formed on the upper surface 1050U (third surface) of the connector shield 1050. The connector shield 1050 has a plurality of positioning portions 1004a formed thereon that are arranged in longitudinal directions (rightward and leftward directions, directions along the X axis) of the housing chamber 1004. This makes it possible to support a plurality of kinds of storage media 100 having different sizes with the spacer 5a.

According to the present embodiment, each positioning portion 1004a is a recess formed in the upper surface 1050U (third surface) of the connector shield 1050. Each positioning portion 1004a may be integrally formed with the upper surface 1050U of the connector shield 1050 by performing sheet-metal processing on the connector shield 1050. As illustrated in FIG. 13A, the width defined by an inner peripheral edge of the recess of each positioning portion 1004a is slightly larger than the width defined by an outer peripheral edge of the hollow cylindrical spacer 5a. The inner peripheral edge of the recess of each positioning portion 1004a guides the spacer 5a by contacting the outer peripheral edge of the spacer 5a. This facilitates the arrangement of the spacer 5a in the housing chamber 1004. Moreover, in the housing chamber 1004, the spacer 5a can be prevented from moving to the outside of the recess of each positioning portion 1004a.

As illustrated in FIG. 11B, the plurality of positioning portions 1004a are disposed outside of an outer edge of the circuit board 1020. Accordingly, the spacer 5a is disposed outside of the outer edge of the circuit board 1020. The connector shield 1050 has an inner region R5 positioned inside of the outer edge of the circuit board 1020 and an outer region R6 positioned outside of the outer edge of the circuit board 1020. Either one of the plurality of positioning portions 1004a is provided in the outer region R6. Therefore, the spacer 5a is disposed in the outer region R6.

As illustrated in FIG. 13A, a mounting hole 1004c is formed in a central position of the recess of each positioning portion 1004a. The recess of each positioning portion 1004a has an outer edge surrounding an outer edge of the mounting hole 1004c. The fixture 5b, not depicted, (see FIG. 2) such as a screw or a rivet may be mounted in a hole formed in the hollow cylindrical spacer 5a and the mounting hole 1004c formed in each positioning portion 1004a. The fixture 5b may be held in contact with a ground part such as a ground pattern mounted on the end 100R of the storage medium 100, and may be electrically connected to the ground part of the storage medium 100. Moreover, the fixture 5b may be held in contact with the connector shield 1050 made of an electrically conductive material such as iron or aluminum at its lower end fitted in the mounting hole 1004c. In this manner, the ground part of the storage medium 100 and the connector shield 1050 can be electrically connected to each other via the fixture 5b.

Further, the spacer 5a may also be made of an electrically conductive material. The spacer 5a that is held in contact with both the ground part of the storage medium 100 and the connector shield 105 allows the ground part of the storage medium 100 and the connector shield 1050 to be electrically connected to each other. This can omit the formation, on the circuit board 1020, of a ground pattern to which the ground part of the storage medium 100 is connected, reducing the cost of the circuit board 1020.

As illustrated in FIG. 12B, the connector shield 1050 has recesses 1004d formed therein that protrude downward from a lower surface 1050D (see FIG. 13A) of the connector shield 1050. The recesses 1004d are formed respectively in front and rear sides of the plurality of positioning portions 1004a arrayed in the rightward and leftward directions, and extend in the rightward and leftward directions. The recesses 1004d formed in the connector shield 1050 can reinforce the connector shield 1050. A recess 1004e is also formed between the positioning portion 1004a on the left end and the positioning portion 1004a next thereto on the right side.

As illustrated in FIGS. 12A and 12B, the connector shield 1050 has a wall 1051F standing along a front side portion (Y1 side portion) of the storage medium 100 and a wall 1051B standing along a rear side portion (Y2 side portion) of the storage medium 100. The walls 1051F and 1051B may be formed by performing sheet-metal processing such as bending on the connector shield 1050. Further, as illustrated in FIG. 12A, the upper board shield 1030 also has 1031B standing along the rear side portion (Y2 side portion) of the storage medium 100 and 1031F standing along the front side portion (Y1 side portion) of the storage medium 100. The walls 1031F and 1031B may also be formed by performing sheet-metal processing such as bending on the upper board shield 1030.

As illustrated in FIG. 11A, a wall standing on the front side of the bottom portion of the housing chamber 1004 is formed by combining the wall 1051F of the connector shield 1050 and the wall 1031F of the upper board shield 1030 with each other. The position of an upper end of the wall 1051F and the position of an upper end of the wall 1031F coincide with each other in the upward and downward directions and also in the forward and backward directions, and a single elastic member 1061F extending straight in the rightward and leftward directions is affixed to the upper ends of these two walls. The upper ends of the walls 1031F and 1051F may be formed by being bent forward. The upper ends thus formed are able to provide a region to which the elastic member 1061F is affixed.

In the example illustrated in FIG. 11A, a wall standing on the rear side of the bottom portion of the housing chamber 1004 is formed by combining the wall 1051B of the connector shield 1050 and the wall 1031B of the upper board shield 1030 with each other. The position of an upper end of the wall 1051B and the position of an upper end of the wall 1031B coincide with each other in the upward and downward directions and also in the forward and backward directions. A single elastic member 1061B is affixed to the upper ends of these two walls. The upper ends of the walls 1031B and 1051B may be formed by being bent backward. The upper ends thus formed are able to provide a region to which the elastic member 1061B is affixed.

As illustrated in FIG. 11A, the walls 1031F, 1031B, 1051F, and 1051B that make up the walls of the housing chamber 1004 have a plurality of holes formed therein.

Air flowing through these holes cools the storage medium 100 housed inside the housing chamber 1004. Further, as illustrated in FIG. 13A, a clearance may be provided between the wall 1031B and the wall 1051B that make up the wall on the rear side of the housing chamber 1004. Similarly, a clearance may be provided between the wall 1031F and the wall 1051F that make up the wall on the front side of the housing chamber 1004. These clearances secure air flow passages for cooling the storage medium 100.

As illustrated in FIG. 11B, the outer region R6 of the connector shield 1050 provided outside of the outer edge of the circuit board 1020 includes a placement area R6' where the storage medium 100 is placed. The placement area R6' represents a region defined along the outer edge of the storage medium 100 with the terminal part attached to the connector 1003 (see FIG. 13A). The placement area R6' of the connector shield 1050 confronts the storage medium 100 that is connected to the connector 1003, and is commensurate with the size of the storage medium 100. As viewed in plan, the size and shape of the placement area R6' coincide with the size and shape of the portion of the storage medium 100 that includes at least the end 100R (see FIG. 2). The at least one positioning portion 1004a may be provided inside the placement area 6'.

FIG. 13B is an enlarged view of a portion of the cross-sectional view of FIG. 13A. As illustrated in FIG. 13B, the upper surface 1050U (third surface) of the connector shield 1050 where each positioning portion 1004a is formed is disposed lower (in the second direction) than the upper surface 1020U (the first surface, an extension of the upper surface 1020U indicated by a two-dot chain line in the cross-sectional view of FIG. 13B) of the circuit board 1020. On the upper surface 1050U of the connector shield 1050, the placement area 6' (see FIG. 13A) where the storage medium 100 is placed is provided lower than the upper surface 1020U of the circuit board 1020. More specifically, the placement area 6' is provided in its entirety lower than the upper surface 1020U of the circuit board 1020. This arrangement allows a desired structure (e.g., a structure required to mount the storage medium 100) to be provided in a region (e.g., the placement area 6') overlapping the storage medium 100 on the upper surface 1050U of the connector shield 1050.

As illustrated in FIG. 13B, an upper end (an end in the first direction) of each positioning portion 1004a provided in the connector shield 1050 is disposed lower (in the second direction) than the upper surface 1020U (first surface) of the circuit board 1020. More specifically, an upper end 1004g of an inner surface of the recess of each positioning portion 1004a provided in the upper surface 1050U of the connector shield 1050 is disposed lower than the upper surface 1020U of the circuit board 1020. This arrangement can secure a space below the storage medium 100, increasing the degree of freedom of the size and layout of components such as integrated circuits mounted on the storage medium 100, in the region 102D (see FIG. 2) below the storage medium 100.

As illustrated in FIG. 12B, the connector shield 1050 has a hole H formed therein. The hole H is formed between the plurality of positioning portions 1004a arrayed in the rightward and leftward directions and an upper wall 1053 that covers the connector 1003. As illustrated in FIG. 11A, the upper surface 1020U of the circuit board 1020 is exposed through the hole H in the connector shield 1050. Moreover, the connector shield 1050 has a peripheral portion 1054 surrounding a front side (Y1 direction side), a rear side (Y2 direction side), and a left side (X2 direction side) of the hole H. The upper wall 1053 that covers the connector 1003 is joined to the peripheral portion 1054. The peripheral portion 1054 of the connector shield 1050 is disposed over a ground pattern 1021 (see FIG. 12A) surrounding the connector 1003 on the upper surface 1020U of the circuit board 1020, and is fixed, along with the upper board shield 1030 and the lower board shield 1040, to the ground pattern 1021 by fixtures such as screws.

As illustrated in FIG. 12B, the connector shield 1050 has steps 1055 between a right side (X1 direction side) of the hole H and the peripheral portion 1054. Because of the steps 1055, the upper surface 1050U of the connector shield 1050 on the right side of the hole H is disposed lower than an upper surface 1054U of the peripheral portion 1054. At least a portion of the peripheral portion 1054 of the connector shield 1050 is disposed over the upper surface 1020U of the circuit board 1020 in the inner region R5 (see FIG. 11B) positioned inside of the outer edge of the circuit board 1020. With this arrangement, in the outer region R6 (see FIG. 11B) positioned outside of the outer edge of the circuit board 20, the upper surface (upper surface on the right side of the hole H) 1050U (see FIG. 12B) of the connector shield 1050 and the upper end 1004g (see FIG. 13B) of the inner surface of the recess of each positioning portion 1004a can be disposed lower than the upper surface 1020U of the circuit board 1020.

As illustrated in FIGS. 12B and 13A, the connector shield 1050 has a dome shape covering the connector 1003 as is the case with the connector shield 50 described with respect to the first embodiment. As illustrated in FIG. 13A, the connector shield 1050 has an electrostatic protecting portion 1052. The electrostatic protecting portion 1052 is formed along an opening of a recess that fits over the storage medium 100 in the connector 1003. The electrostatic protecting portion 1052 is positioned in the rightward direction (X1 direction) of the connector 1003. The electrostatic protecting portion 1052 is bent downward from an end (right end) of the upper wall 1053 on the side of the housing chamber 1004. For example, when the operator attaches or removes the storage medium 100 to or from the connector 1003, the finger of the operator moves with the storage medium 100 in the direction of the connector 1003. At this time, the electrostatic protecting portion 1052 is interposed between the finger of the operator and the connector 1003, allowing static electricity accumulated on the finger of the operator to flow to the electrostatic protecting portion 1052. A clearance that is larger than the width of the electrostatic protecting portion 1052 in the upward and downward directions may be secured between the upper wall 1053 and the connector 1003. The clearance can cause the static electricity that is received by the electrostatic protecting portion 1052, to pass through a route remote from the connector 1003 by way of the upper wall 1053.

As described above, the upper surface 1050U (third surface) of the connector shield 1050 where the at least one positioning portion 1004a is formed is disposed lower (in the second direction) than the upper surface 1020U of the circuit board 1020. This arrangement allows a desired structure to be provided in a region (e.g., the placement area 6') overlapping the storage medium 100 on the upper surface 1050U of the connector shield 1050.

Moreover, according to the present embodiment, the upper end (the end in the first direction) of the at least one positioning portion 1004a is also disposed lower than the upper surface 1020U of the circuit board 1020. More specifically, the upper surface 1050U of the connector shield 1050 and the upper end of the inner surface of the recess of each positioning portion 1004a are formed lower than the upper surface 1020U of the circuit board 1020. This arrangement can secure a space below the storage medium 100, increasing the degree of freedom of the size and layout of components such as integrated circuits mounted on the storage medium 100, in the region below the storage medium 100.

Moreover, according to the present embodiment, the ground part that is provided on the end 100R of the storage medium 100 may be held in contact with and electrically connected to the connector shield 1050 via the spacer 5a and the fixture 5b. This can omit a structure to which the spacer 5a and the fixture 5b would be attached, from the circuit board 1020, reducing the cost of the circuit board 1020.

Moreover, according to the present embodiment, the connector shield 1050 has the electrostatic protecting portion 1052 disposed along the opening of the connector 1003 to which the storage medium 100 is detachably connected. With this arrangement, when static electricity is generated on the finger or the like of the user at the time the storage medium 100 is attached or detached, the static electricity can flow through the electrostatic protecting portion 1052 to the connector shield 1050.

## Claims

1. An electronic device that is able to have a storage medium installed thereon, the storage medium having a first end with a terminal part formed thereon and a second end opposite to the first end, the electronic device comprising:
a circuit board having a first surface facing in a first direction and a second surface facing in a second direction that is opposite to the first direction;
a connector mounted on the first surface of the circuit board, the first end of the storage medium being connectable to the connector; and
a member different from the circuit board,
wherein the member different from the circuit board has a third surface facing in the first direction and has at least one positioning portion formed on the third surface for positioning a spacer that supports the second end of the storage medium, and
the third surface is positioned in a direction along the circuit board with respect to the connector and
positioned in the second direction rather than the first surface of the circuit board.

2. The electronic device according to claim 1, wherein an end of the at least one positioning portion in the first direction is positioned in the second direction rather than the first surface of the circuit board.

3. The electronic device according to claim 1, wherein the at least one positioning portion is at least one protrusion that protrudes from the third surface in the first direction, and
an end of the at least one protrusion in the first direction is disposed in the second direction rather than the first surface of the circuit board.

4. The electronic device according to claim 3, further comprising:
a fixture that fixes the second end of the storage medium through the spacer to the member different from the circuit board,
wherein the member different from the circuit board further has a mounting hole to which the fixture is to be mounted, and
the at least one protrusion is formed along an outer edge of the mounting hole.

5. The electronic device according to claim 1, wherein the at least one positioning portion is a recess that is recessed from the third surface in the second direction, and
the third surface and an end in the first direction of an inner surface of the recess are disposed in the second direction rather than the first surface of the circuit board.

6. The electronic device according to claim 5, further comprising:
a fixture that fixes the second end of the storage medium through the spacer to the member different from the circuit board,
wherein the member different from the circuit board further has a mounting hole to which the fixture is to be mounted, and
an outer edge of the recess surrounds an outer edge of the mounting hole.

7. The electronic device according to claim 1, wherein the member different from the circuit board is a circuit board shield covering the second surface of the circuit board.

8. The electronic device according to claim 1, wherein the member different from the circuit board is a connector shield covering the connector.

9. The electronic device according to claim 1, wherein the member different from the circuit board has a wall standing along a side of the storage medium attached to the connector.

10. The electronic device according to claim 1, wherein the at least one positioning portion is provided in an outer region positioned outside of an outer edge of the circuit board.

11. The electronic device according to claim 10, wherein the outer region includes a placement area where the storage medium is to be placed, the placement area being defined along an outer edge of the storage medium attached to the connector, and
the placement area is provided in the second direction rather than the first surface of the circuit board.
